# EUROPEAN PATENT APPLICATION

(11) **EP 4 800 679 A1**
(43) Date of publication of application: **02.09.2026**
(21) Application number: 25829580.7
(22) Date of filing: 26.05.2025
(51) Int. Cl.: G09G 3/20, H10K 59/131

(54) **DISPLAY SCREEN AND ELECTRONIC DEVICE**

(30) Priority: 21.06.2024 CN 202410816388
(71) Applicant: Huawei Technologies Co., Ltd., Shenzhen, Guangdong 518129 (CN)
(72) Inventor: ZHANG, Hu, Shenzhen, Guangdong 518129 (CN); CHENG, Lv, Shenzhen, Guangdong 518129 (CN); ZHANG, Rui, Shenzhen, Guangdong 518129 (CN); FENG, Yanbin, Shenzhen, Guangdong 518129 (CN)
(74) Representative: Epping - Hermann - Fischer
(86) International application number: PCT/CN2025/097056
(87) International publication number: WO 2025/261099

(57) **Abstract**

Embodiments of this application provide a display and an electronic device, and belong to the field of electronic device technologies. A display panel of the display includes a gate control line and a plurality of pixel groups that are sequentially distributed. The gate control line is connected to pixel units in the pixel group via a gate drive circuit. A gate control signal transmitted by the gate control line may be transmitted to the gate drive circuit, to drive and control the pixel units in the pixel group to emit light and turn off row by row. A first end and a second end of the gate control line are connected to a power supply chip, and a gate control signal of the power supply chip is separately introduced from the first end and the second end into the gate control line, so that the gate control signal is introduced into the gate control line from two opposite ends of the gate control line for simultaneous driving. This reduces voltage attenuation and a resistive-capacitive delay during transmission of the gate control signal, improves a drive capability, improves drive effect on the plurality of pixel groups, and helps improve display effect and display uniformity of the display panel.

## Description

This application claims priority to Chinese Patent Application No. 202410816388.6, filed with the China National Intellectual Property Administration on June 21, 2024 and entitled "DISPLAY AND ELECTRONIC DEVICE", which is incorporated herein by reference in its entirety.

### TECHNICAL FIELD

This application relates to the field of electronic device technologies, and in particular, to a display and an electronic device.

### BACKGROUND

Display panels have become indispensable functional components in electronic terminal devices such as mobile phones, tablets, and notebook computers. The display panel includes a drive circuit, and the drive circuit is configured to drive and control displaying of the display panel. A gate driver on array (gate driven on array, GOA for short) technology is a technology of gate-driven integration on an array substrate, can implement a progressive scanning drive function for the display panel, and has advantages such as high integration and low manufacturing costs. The GOA technology has gradually become a research hotspot.

For example, in an organic light-emitting diode (organic light-emitting diode, OLED for short) display panel made of OLEDs, the display panel may include a gate control line, gate drive circuits, and a plurality of pixel groups. The display panel may further include a display area and a peripheral area (non-display area) surrounding a periphery of the display area. A plurality of pixel units are located in the display area, and the gate control line and the gate drive circuits may be located in the peripheral area. The plurality of pixel groups are sequentially distributed into a plurality of rows, each pixel group may include a plurality of pixel units, and one gate drive circuit is correspondingly connected to a plurality of pixel units in one pixel group. The peripheral area includes a bottom peripheral area and a top peripheral area. The bottom peripheral area and the top peripheral area are respectively located outside two sides of the display area. A first end of the gate control line is usually located in the bottom peripheral area, and is electrically connected to a power supply chip via a drive chip in the bottom peripheral area. A second end of the gate control line extends towards the top peripheral area and is electrically connected to the plurality of gate drive circuits. A gate control signal output by the power supply chip is introduced into the gate control line from the first end in the bottom peripheral area, and is transmitted to a gate drive unit, to implement drive and control on the plurality of rows of pixel units level by level.

However, the control signal of the gate control line is introduced from the first end in the bottom peripheral area and transmitted along the gate control line, to implement drive and control on pixel units in the plurality of pixel groups. A trace of the gate control line is long, especially in an electronic device that can implement large-screen displaying. Consequently, tracing impedance is large, resulting in voltage attenuation and a large resistive-capacitive delay (RC delay), and affecting drive effect.

### SUMMARY

Embodiments of this application provide a display and an electronic device, to reduce voltage attenuation of a gate control signal and a resistive-capacitive delay, improve a drive capability, and help improve display effect and display uniformity of the display.

A first aspect of embodiments of this application provides a display, including a display panel. The display panel includes a display area and a first peripheral area that are adjacent to each other in a first direction.

The display panel further includes a gate control line and a plurality of pixel groups. The plurality of pixel groups are located in the display area, the plurality of pixel groups are sequentially arranged in a second direction, each pixel group includes a plurality of pixel units sequentially arranged in the first direction, and the first direction intersects the second direction.

A gate control line is disposed in at least the first peripheral area, the gate control line extends along the second direction, and the gate control line is electrically connected to the plurality of pixel units in at least one pixel group. The gate control line is configured to transmit a gate control signal, to control the pixel units in the plurality of pixel groups to emit light or turn off. For example, the display may further include a drive circuit group. Each drive circuit group includes a plurality of gate drive circuits, and one gate drive circuit is correspondingly connected to the plurality of pixel units in one pixel group. One drive circuit group is connected to at least one gate control line, and each gate control line is connected to at least one gate drive circuit in the drive circuit group, and is further connected to the pixel units in at least one pixel group.

The gate control line is configured to receive a gate control signal output from a power supply chip of an electronic device. The gate control signal may be transmitted to the gate control line, and transmitted to one or more gate drive circuits along the gate control line, to implement drive and control on pixel units in the plurality of pixel groups row by row.

The gate control line includes a first end and a second end that are opposite to each other in the second direction, the first end and the second end are configured to electrically connect to the power supply chip, and a gate control signal output by the power supply chip may be separately transmitted from the first end and the second end to the gate control line, that is, the gate control signal may be input from both the first end and the second end of the gate control line. The gate control signal may be introduced into the gate control line from the first end, transmitted along the gate control line to the second end, and transmitted to the gate drive circuit, to drive the pixel units in the plurality of pixel groups row by row. The gate control signal may also be introduced into the gate control line from the second end, transmitted along the gate control line to the first end, and transmitted to the gate drive circuit, to drive the pixel units in the plurality of pixel groups row by row.

In this case, the gate control signal is introduced from the two opposite ends of the gate control line in the second direction for simultaneous driving, and the gate control signal is introduced from the first end and transmitted to the gate drive circuit. Consequently, voltage attenuation occurs in the gate control signal, that is, voltage attenuation occurs in a process of transmitting the gate control signal from the first end to the second end. Voltage attenuation also occurs in the gate control signal that is introduced from the second end and transmitted to the gate drive circuit along the gate control line. However, the two parts of the gate control signal are superimposed for simultaneous driving, to ensure that a voltage of a gate control signal input into each gate drive circuit is high. This reduces voltage attenuation of the gate control signal transmitted to the gate drive circuit and a resistive-capacitive delay, improves a drive capability, improves drive uniformity and drive effect on the plurality of pixel groups, and further improves display effect and display uniformity of the display panel. This also helps reduce drive power consumption while ensuring display effect of the display.

In a possible implementation, a peripheral area further includes a second peripheral area and a third peripheral area, and the second peripheral area and the third peripheral area are respectively located outside two sides of the display area in the second direction.

The first end of the gate control line is located in the second peripheral area, and the second end of the gate control line is located outside a side that is of the third peripheral area and that backs on the display area. When the gate control signal is introduced from the two sides of the gate control line for simultaneous driving, an implementation in which the first end of the gate control line is connected to the power supply chip changes slightly, feasibility is high, and this helps reduce structural design difficulty and manufacturing costs.

In a possible implementation, the display further includes a first circuit board, the second end of the gate control line is electrically connected to the first circuit board, and the first circuit board is configured to electrically connect to the power supply chip, so that the second end of the gate control line is electrically connected to the power supply chip. An implementation of the design is simple, which facilitates production and assembly.

In a possible implementation, a first conductive pad is disposed on the second end of the gate control line, and a second conductive pad is disposed on the first circuit board.

The display further includes a conductive adhesive layer, and the first conductive pad and the second conductive pad are fastened and electrically connected via the conductive adhesive layer. The implementation is simple and fast, and feasibility is high, which helps reduce production difficulty.

In a possible implementation, the display further includes a drive chip, the drive chip is located in the second peripheral area, the first end of the gate control line is electrically connected to the drive chip, and the drive chip is configured to electrically connect to the power supply chip. The drive chip may be electrically connected to the gate control line, and the drive chip may implement boost processing and the like on the gate control signal, so that the gate control signal can meet a voltage range requirement of the gate drive circuit. This ensures drive effect.

In a possible implementation, the display further includes a second circuit board, the drive chip is electrically connected to the second circuit board, the second circuit board is configured to electrically connect to a third circuit board on which the power supply chip is disposed, and the first circuit board is configured to electrically connect to the third circuit board, so that the first end of the gate control line is electrically connected to the power supply chip on the third circuit board via the drive chip and the second circuit board.

In a possible implementation, the display panel further includes a substrate, the substrate includes a first surface and a second surface that are opposite to each other, the first surface may be divided into the display area and the peripheral area, and the drive chip, at least a part of the gate control line, and the pixel units are located on the first surface.

The first circuit board includes a first sub-circuit board and a second sub-circuit board, the first sub-circuit board is electrically connected to the second end of the gate control line, and the first sub-circuit board is disposed adjacent to the third peripheral area. This helps implement the connection, and helps reduce impedance caused by connection paths.

The second circuit board is disposed adjacent to the second peripheral area, and at least a part of the second sub-circuit board is located on the second surface, so that the second sub-circuit board and the substrate at least partially overlap in a thickness direction. One end of the second sub-circuit board is electrically connected to the first sub-circuit board, and the other end of the second sub-circuit board is configured to electrically connect to the third circuit board that is disposed adjacent to the second circuit board. Therefore, the first sub-circuit board and the third circuit board that are distributed on two sides of the display in the second direction are electrically connected, without affecting display effect of the display area.

In a possible implementation, the first sub-circuit board and the second sub-circuit board each include a flexible circuit board. Therefore, the first sub-circuit board can be bent, to help reduce space occupied by the first sub-circuit board in the second direction, and further reduce a length of the display. The second sub-circuit board can be bent, to help connect the second sub-circuit board to the third circuit board.

A first connector is disposed on the second sub-circuit board, and the first connector is configured to electrically connect to the third circuit board. Therefore, the first sub-circuit board can be bent, to reduce space occupied by the first sub-circuit board in the second direction, and further reduce space occupied by the entire display in the second direction.

In a possible implementation, the display further includes a second connector, and the first sub-circuit board is electrically connected to the second sub-circuit board via the second connector. The first sub-circuit board and the second sub-circuit board may be separately formed, and then assembled together via the second connector. Compared with an integrated structure of the first sub-circuit board and the second sub-circuit board, the structures of the first sub-circuit board and the second sub-circuit board are simple, the separate forming process is simple and easy to implement, and the disposed locations of the first sub-circuit board and the second sub-circuit board are flexible, to meet a plurality of layout requirements.

In a possible implementation, a third connector is disposed on the first circuit board, and a fourth connector is disposed on the second circuit board.

The third connector and the fourth connector are respectively configured to electrically connect to two interconnected third circuit boards. This increases flexibility of connecting the gate control line to the power supply chip, and expands applicable ranges.

In a possible implementation, the peripheral area further includes the first peripheral area and a fourth peripheral area, the first peripheral area and the fourth peripheral area are respectively located outside the two sides of the display area in the first direction, and the gate control line is distributed in the first peripheral area and the fourth peripheral area. In the first direction, at least one gate drive circuit can be connected to each of two sides of one pixel group, and the gate drive circuit is connected to the power supply chip via the gate control line. Therefore, the gate drive circuits on the two sides of the pixel group can simultaneously provide a gate control signal for the pixel units in the pixel group, to drive and control the pixel units to emit light and turn off, help improve uniformity of luminance of the pixel units, and improve display effect.

In a possible implementation, the gate control line includes one or more of a start signal line, a gate high voltage signal line, a gate low voltage signal line, and a clock signal line.

In a possible implementation, the gate control line includes the gate high voltage signal line and the gate low voltage signal line, to ensure that the display panel has good display uniformity while reducing design difficulty of the gate control line structure.

A second aspect of embodiments of this application provides an electronic device, including a power supply chip, a middle frame, and the foregoing display. The display is fastened to the middle frame. The middle frame includes a middle plate and a side frame, the side frame is disposed around the middle plate, a second surface of a substrate of a display panel is opposite to a surface of the middle plate, and pixel units may be located on a first surface of the substrate, to meet display requirements such as a graphic. The power supply chip is electrically connected to a first end and a second end of a gate control line of the display, so that a gate control signal output by the power supply chip is separately transmitted from the first end and the second end to the gate control line.

In a possible implementation, the electronic device further includes a third circuit board, the power supply chip is disposed on the third circuit board and is electrically connected to the third circuit board, and the third circuit board is electrically connected to a first circuit board and a second circuit board of the display.

The display, the power supply chip, and the third circuit board are located on one side of the middle plate. During actual assembly, the display may be first formed, and then the display is attached to one surface of the middle frame. The third circuit board and the power supply chip are assembled on the surface, and the third circuit board is connected to the second circuit board and the first circuit board. The assembly manner is simple and easy to operate.

In a possible implementation, the display panel and a drive chip of the display are located on one side of the middle plate, and the third circuit board and the power supply chip are located on a surface that is of the middle plate and that backs on the display panel. The middle plate is provided with a first through hole and a second through hole, a part of a first circuit of the display passes through the first through hole and is electrically connected to the third circuit board, and a part of the second circuit board of the display passes through the second through hole and is electrically connected to the third circuit board. In comparison with the display, the third circuit board, and the like all being located on one side of the middle plate, the third circuit board and the first circuit board between the second surface of the substrate and the middle plate are not disposed on middle plate, to help reduce overall thickness of the display and the middle plate.

In a possible implementation, the electronic device further includes a rotating shaft, there are at least two middle frames, the two middle frames are respectively disposed on two sides of the rotating shaft, the two middle frames rotatably fit with each other via the rotating shaft, and the display is disposed on the at least two middle frames and the rotating shaft. The power supply chip and the third circuit board are separately disposed in the two middle frames, and the rotating shaft is provided with a cross-shaft hole.

The electronic device further includes a fourth circuit board, and the fourth circuit board passes through the cross-shaft hole and is electrically connected to the two third circuit boards.

A third aspect of embodiments of this application provides a display panel, including a display area and a first peripheral area that are adjacent to each other in a first direction.

The display panel further includes a gate control line and a plurality of pixel groups. The plurality of pixel groups are located in the display area, the plurality of pixel groups are sequentially arranged in a second direction, each pixel group includes a plurality of pixel units sequentially arranged in the first direction, and the first direction intersects the second direction.

The gate control line is disposed in at least the first peripheral area, the gate control line extends along the second direction, and the gate control line is electrically connected to the plurality of pixel units in at least one pixel group. The gate control line includes a first end and a second end that are opposite to each other in the second direction, the first end and the second end are configured to electrically connect to a power supply chip of an electronic device, and a gate control signal output by the power supply chip is separately transmitted from the first end and the second end to the gate control line.

The gate control signal is introduced from the gate control line along two opposite ends in the second direction for simultaneous driving. The two parts of the gate control signal are superimposed for simultaneous driving, to ensure that a voltage of a gate control signal input into each gate drive circuit is high. This reduces voltage attenuation of the gate control signal transmitted to the gate drive circuit and a resistive-capacitive delay, improves a drive capability, improves drive uniformity and drive effect on the plurality of pixel groups, and further improves display effect and display uniformity of the display panel.

In a possible implementation, a peripheral area further includes a second peripheral area and a third peripheral area, and the second peripheral area and the third peripheral area are respectively located outside two sides of the display area in the second direction. The first end of the gate control line is located in the second peripheral area, and the second end of the gate control line is located outside a side that is of the third peripheral area and that backs on the display area.

In a possible implementation, the peripheral area further includes a fourth peripheral area, the first peripheral area and the fourth peripheral area are respectively located outside the two sides of the display area in the first direction, and the gate control line is distributed in the fourth peripheral area.

In a possible implementation, the gate control line includes one or more of a start signal line, a gate high voltage signal line, a gate low voltage signal line, and a clock signal line.

### BRIEF DESCRIPTION OF DRAWINGS

FIG. 1 is a diagram of a structure of an electronic device in a folded state according to an embodiment of this application;
FIG. 2 is a diagram of a structure of the electronic device shown in FIG. 1 in an intermediate state;
FIG. 3 is a diagram of a structure of the electronic device shown in FIG. 1 in an unfolded state;
FIG. 4 is a diagram of a split structure of the electronic device shown in FIG. 1;
FIG. 5 is a diagram of a split structure of a display in FIG. 4;
FIG. 6 is a front view of a display panel in FIG. 5;
FIG. 7 is a diagram of a structure of a display panel in FIG. 6;
FIG. 8 is a diagram of tracing of a gate control line in an electronic device in a related technology;
FIG. 9 is a diagram of a circuit connection structure of pixel units, gate drive circuits, and gate control lines in the display panel in FIG. 7;
FIG. 10 is another diagram of tracing of a gate control line of a display in an electronic device according to this application;
FIG. 10a is still another diagram of tracing of a gate control line of a display in an electronic device according to an embodiment of this application;
FIG. 11 is a diagram of a structure of connection between the gate control line in FIG. 10 and a first circuit board;
FIG. 12 is a partially enlarged cross-sectional view of the connection between the gate control line and the first circuit board in FIG. 11;
FIG. 13 is a diagram of a back structure of a display panel in the electronic device in FIG. 10;
FIG. 14 is another diagram of a back structure of a display in an electronic device according to an embodiment of this application;
FIG. 14a is another partial side view of an electronic device according to an embodiment of this application;
FIG. 14b is a diagram of assembly of a display and a middle plate of a middle frame in FIG. 14a;
FIG. 14c is another diagram of assembly of a display and a middle plate in an electronic device according to an embodiment of this application;
FIG. 15a is another diagram of a structure of connection between a display and a third circuit board according to an embodiment of this application;
FIG. 15b is a side view of a structure of connection between the display and the third circuit board in FIG. 15a;
FIG. 16 is a diagram of assembly of the display in FIG. 15b and a middle plate of a middle frame;
FIG. 17 is another diagram of assembly of a display and a middle plate in an electronic device according to an embodiment of this application; and
FIG. 18 is a diagram of an assembly process of the display and the middle plate in FIG. 17.

### Reference numerals:

100: electronic device;
101: rotating shaft;
102: middle frame; 102a: first middle frame; 102b: second middle frame;
103: display;
   10: display panel;
      11: substrate; 12: pixel group; 121: pixel unit; 1211: pixel circuit; 1212: subpixel;
      13: drive circuit group; 131: gate drive circuit;
      14: source drive circuit;
      15: gate control line; 151: first end; 152: second end; 1521: first conductive pad;
      16: data line; 17: drive chip;
      19: first circuit board; 191: first sub-circuit board; 1911: second conductive pad; 192: second sub-circuit board; 111: conductive adhesive layer;
      113: first connector; 114: second connector; 115: mainboard connector; 116: fourth circuit board;
      117: third connector; 118: fourth connector;
   20: cover; 30: polarizer; 40: protective film; 50: support film;
104: rear cover; and
105: main circuit board.

### DESCRIPTION OF EMBODIMENTS

Terms used in implementations of this application are only used to explain specific embodiments of this application, but are not intended to limit this application.

Electronic devices provided in embodiments of this application may include but are not limited to electronic devices with a display, for example, a television, a display, a mobile phone, a tablet computer, a notebook computer, a desktop computer, an all-in-one computer, an ultra-mobile personal computer (ultra-mobile personal computer, UMPC for short), a handheld computer, a touch television, a walkie-talkie, a netbook, a POS machine, a personal digital assistant (personal digital assistant, PDA for short), a wearable device (for example, a watch, a band, a smartwatch, or a smart band), a virtual reality (virtual reality, VR for short) device and a mixed reality (mixed reality, MR for short) device (for example, VR glasses, AR glasses, an AR helmet, a VR helmet, and an MR helmet), and a vehicle-mounted device.

The electronic device may include a middle frame, and a display may be disposed on the middle frame. The middle frame may implement support and assembly of the display. The display is configured to display an image, a text, a video, and the like, and provide an interaction interface for a user.

The display may be an organic light-emitting diode (organic light-emitting diode, OLED for short) display. Certainly, in some examples, the display may alternatively be a micro organic light-emitting diode (micro organic light-emitting diode) display, an active-matrix organic light-emitting diode or active-matrix organic light-emitting diode (active-matrix organic light-emitting diode, AMOLED for short) display, a light-emitting diode (light-emitting diode, LED for short) display, a mini light-emitting diode (mini organic light-emitting diode, Mini LED for short) display, a micro light-emitting diode (micro organic light-emitting diode, Micro LED for short) display, a quantum dot light-emitting diode (quantum dot light-emitting diode, QLED for short) display, a liquid crystal display (liquid crystal display, LCD for short), or the like.

In embodiments of this application, an example in which the display is an organic light-emitting diode display is used for description.

The electronic device may be an electronic device whose display is not foldable. For example, the electronic device is a mobile phone, and the electronic device may be a bar-type mobile phone, for example, a bar-type mobile phone in a landscape mode or a bar-type mobile phone in a portrait mode. For example, the mobile phone may include one middle frame whose outline is in a tablet shape, and the display is disposed on the middle frame. The display may also be in a tablet-shaped structure, and neither the display nor the middle frame can be folded.

Alternatively, the electronic device may be an electronic device with a foldable display. For example, the electronic device is a mobile phone, and the mobile phone may be a foldable smartphone like a foldable smartphone in a landscape mode or a foldable smartphone in a portrait mode. For example, the mobile phone may include at least two middle frames. The two middle frames may rotate relative to each other to fold or unfold, and the display is disposed on the at least two middle frames. The display may be a flexible display. The flexible display is flexible, and can be freely bent, wound, or folded, so that the display can be folded or unfolded as the middle frame is folded or unfolded.

The electronic device is a foldable electronic device. For example, when the electronic device is a foldable smartphone, the foldable smartphone may be a foldable smartphone with an outward-foldable display. Alternatively, the foldable smartphone may be a foldable smartphone with an inward-foldable display. Alternatively, for the foldable smartphone, a part of the display may be inward foldable, another part of the display may be outward foldable, and the like.

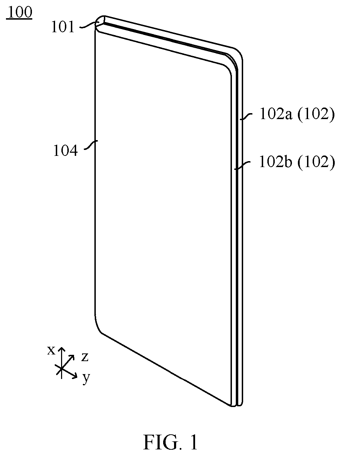

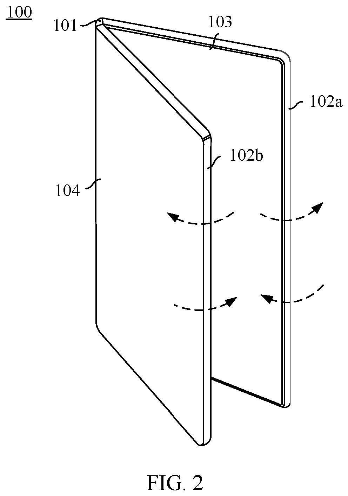

In embodiments of this application, a foldable smartphone with an inward-foldable display is used as an example for description. FIG. 2 is a diagram of a structure of the electronic device shown in FIG. 1 in an intermediate state.

FIG. 1 is a diagram of a structure of an electronic device in a folded state according to an embodiment of this application.

With reference to FIG. 1 and FIG. 2, an electronic device 100 may include a rotating shaft 101, a middle frame 102, and a display 103. There may be at least two middle frames 102. For example, there are two middle frames 102: a first middle frame 102a and a second middle frame 102b. The first middle frame 102a and the second middle frame 102b may be located on two sides of the rotating shaft 101, and the first middle frame 102a and the second middle frame 102b are connected to the rotating shaft 101.

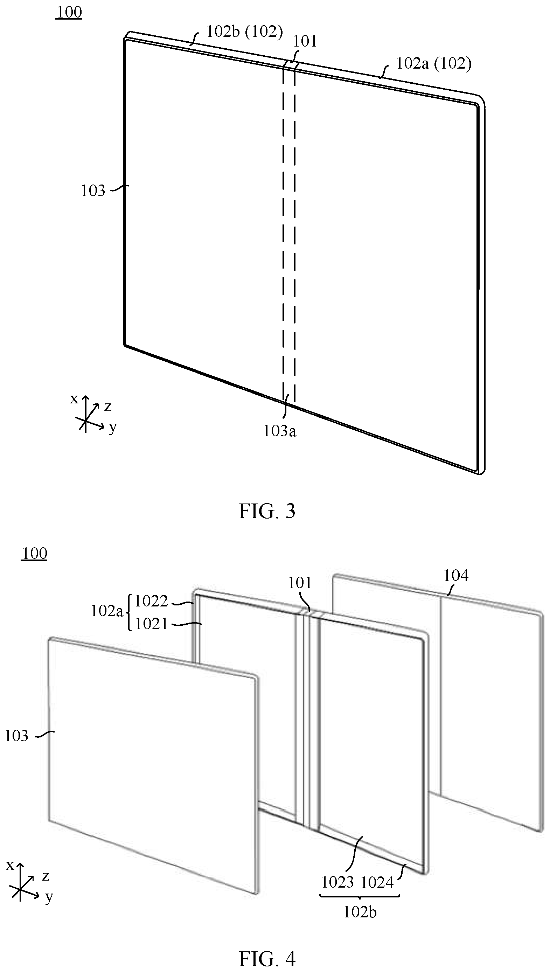

The display 103 may be disposed on the rotating shaft 101 and the middle frame 102. For example, the display 103 may be located on a same side surface of the first middle frame 102a, the second middle frame 102b, and the rotating shaft 101. A part that is of the display 103 and that is opposite to the first middle frame 102a (opposite in a thickness direction) may be disposed on the first middle frame 102a in a flat manner, and a part that is of the display 103 and that is opposite to the second middle frame 102b may be disposed on the second middle frame 102b in a flat manner. A part that is of the display 103 and that is opposite to the rotating shaft 101 may be a bending area (refer to a bending area 103a in FIG. 3) of the display 103, and an extension direction of the bending area may be consistent with an axial direction of the rotating shaft.

The rotating shaft 101 may be a structural component configured to connect the two middle frames 102 and allow the two middle frames 102 to rotate relative to each other. The first middle frame 102a and the second middle frame 102b may rotatably fit with each other via the rotating shaft 101, so that the first middle frame 102a and the second middle frame 102b can rotate relative to each other, and the first middle frame 102a and the second middle frame 102b are further folded or unfolded. The display 103 may be folded or unfolded as the first middle frame 102a and the second middle frame 102b move, so that the electronic device 100 switches between a folded state and an unfolded state.

The first middle frame 102a and the second middle frame 102b can be folded relative to each other to a closed state. Refer to FIG. 1. For example, when the first middle frame 102a and the second middle frame 102b are in the closed state, the first middle frame 102a and the second middle frame 102b can be completely closed to be parallel to each other (a slight deviation is allowed). In this case, the entire electronic device 100 is in the closed state, which is also referred to as the folded state. The part (the bending area of the display) that is of the display 103 and that is opposite to the rotating shaft 101 may be bent and in the folded state.

Refer to FIG. 2. The first middle frame 102a and the second middle frame 102b can rotate relative to each other (folded or unfolded) to the intermediate state, so that the electronic device 100 is in the intermediate state. The part (the bending area of the display) that is of the display 103 and that is opposite to the rotating shaft 101 is also in the intermediate state as the display 103 is folded or unfolded.

FIG. 3 is a diagram of a structure of the electronic device shown in FIG. 1 in the unfolded state.

Refer to FIG. 3. The first middle frame 102a and the second middle frame 102b can be unfolded relative to each other to an open state. For example, the first middle frame 102a and the second middle frame 102b are in the open state, an unfolded angle between the first middle frame 102a and the rotating shaft 101 and an unfolded angle between the rotating shaft 101 and the second middle frame 102b may be approximately 180°, and the entire electronic device 100 is in the open state, which is also referred to as the unfolded state. The part (the bending area 103a of the display) that is of the display 103 and that is opposite to the rotating shaft 101 is also unfolded as the display 103 is unfolded, that is, the entire display 103 can be unfolded to a plane at an angle of approximately 180°.

It should be noted that a slight deviation is allowed in the angle described in the example in this embodiment of this application. For example, the unfolded angle (or unfolded angle of the display 103) of the electronic device 100 shown in FIG. 3 may be 180°, or may be approximately 180°, for example, 170°, 175°, 185°, or 190°.

The intermediate state shown in FIG. 2 may be any state between the folded state and the unfolded state. In other words, the middle frames 102 and the display 103 of the electronic device 100 may switch between the unfolded state (namely, the open state) and the folded state (namely, the closed state) as the rotating shaft 101 moves, to implement opening and closing of the electronic device 100.

For example, when the electronic device 100 is in the unfolded state, the first middle frame 102a and the second middle frame 102b rotate towards each other and are folded relative to each other, so that the electronic device 100 can switch from the unfolded state to the folded state (or the intermediate state). When the electronic device 100 is in the folded state, the first middle frame 102a and the second middle frame 102b rotate away from each other and are unfolded relative to each other, so that the electronic device 100 can switch from the folded state to the unfolded state (or the intermediate state).

For example, in this embodiment of this application, as shown in FIG. 3, a width direction of the middle frame 102 (for example, the first middle frame 102a) is an x direction, a length direction of the middle frame 102 is a y direction, and a thickness direction of the middle frame 102 is a z direction. The width direction, the length direction, and the thickness direction may intersect each other. For example, the middle frame 102 may be of a rectangular plate-shaped structure, and the width direction, the length direction, and the thickness direction may be perpendicular to each other.

It may be understood that the length, the width, and the thickness in this embodiment of this application are merely for ease of description, and do not mean any limitation on a size. For example, the length may be greater than, equal to, or less than the width.

Certainly, in some other examples, the middle frame 102 may alternatively be of a plate-shaped structure in a shape like a square, a circle, an ellipse, or a rounded rectangle.

It should be noted that the electronic device 100 may include only two middle frames 102. For example, there may be one first middle frame 102a and one second middle frame 102b, so that the electronic device 100 is in the folded state, and the first middle frame 102a and the second middle frame 102b are folded relative to each other into two layers. For example, the electronic device 100 includes one first middle frame 102a, one second middle frame 102b, and one rotating shaft 101. The first middle frame 102a and the second middle frame 102b are rotatably connected via the rotating shaft 101. When the first middle frame 102a and the second middle frame 102b are folded relative to each other and are in the folded state, the electronic device 100 is in a form in which two layers of middle frames 102 are stacked (refer to FIG. 1).

Alternatively, the electronic device 100 may include more than two middle frames 102. For example, at least one of the first middle frame 102a and the second middle frame 102b may be plural, and there may be a plurality of rotating shafts 101. A first middle frame 102a and a second middle frame 102b that are adjacent may be connected via one rotating shaft 101, so that the electronic device 100 can be folded into a multi-layer form.

For example, the electronic device 100 may include two first middle frames 102a, one second middle frame 102b, and two rotating shafts 101. The two first middle frames 102a are located on two sides of the second middle frame 102b, and each of the two first middle frames 102a is rotatably connected to the second middle frame 102b via one rotating shaft 101. One first middle frame 102a may be folded relative to the second middle frame 102b, and the other first middle frame 102a may also be folded relative to the second middle frame 102b, so that the electronic device 100 is in the folded state, and the first middle frames 102a and the second middle frame 102b are folded relative to each other to form a form in which three layers of the middle frames 102 are stacked. When one first middle frame 102a and the second middle frame 102b is unfolded relative to each other to the unfolded state, the electronic device 100 is in the unfolded state.

For a foldable electronic device with an outward-foldable display, the display 103 may be disposed on outer surfaces of the first middle frame 102a, the second middle frame 102b, and the rotating shaft 101. For a foldable electronic device with an inward-foldable display, the display 103 may be disposed on inner surfaces of the first middle frame 102a, the second middle frame 102b, and the rotating shaft 101.

When the electronic device 100 is in the folded state, two adjacent and opposite surfaces of the first middle frame 102a and the second middle frame 102b may respectively be the inner surfaces of the first middle frame 102a and the second middle frame 102b, a surface that is of the rotating shaft 101 and that is located on a same side as the inner surfaces of the first middle frame 102a and the second middle frame 102b is the inner surface of the rotating shaft 101. Two surfaces that back on each other and that are of the first middle frame 102a and the second middle frame 102b are respectively outer surfaces of the first middle frame 102a and the second middle frame 102b.

A surface that is of the rotating shaft 101 and that is located on a same side as the outer surfaces of the first middle frame 102a and the second middle frame 102b is the outer surface of the rotating shaft 101.

Alternatively, in some examples, when there are more than two middle frames 102, a part of the display 103 may be located on outer surfaces of some middle frames 102, and another part of the display 103 may be located on inner surfaces of some middle frames 102. For example, when the foregoing electronic device 100 includes two first middle frames 102a, one second middle frame 102b, and two rotating shafts 101, the display 103 is disposed on the two first middle frames 102a, the second middle frame 102b, and the rotating shafts 101. For example, a part of the display 103 may be located on inner surfaces of one first middle frame 102a, one rotating shaft 101, and the second middle frame 102b, and another part of the display 103 may be located on an outer surface of the other first middle frame 102a.

In this embodiment of this application, an example in which the electronic device 100 includes two middle frames: the first middle frame 102a and the second middle frame 102b, and the first middle frame 102a and the second middle frame 102b rotatably fit with each other via one rotating shaft 101 is used for description.

FIG. 4 is a diagram of a split structure of the electronic device shown in FIG. 1.

As shown in FIG. 4, the electronic device 100 may further include a rear cover 104. The display 103 and the rear cover 104 may be respectively located on two opposite sides of the middle frame 102 and the rotating shaft 101 along the thickness direction (z direction). The rear cover 104, the display 103, and the middle frame 102 jointly enclose accommodation space, and structural members of the electronic device 100 may be assembled and accommodated in the accommodation space.

A side that is of the display 103 and that backs on the rear cover 104 may be used as a display surface of the electronic device 100. The rear cover 104 may be used as an appearance cover of a rear side of the electronic device 100, to protect the structural members in the accommodation space of the electronic device 100 and improve the aesthetics of the electronic device 100.

The middle frame 102 may include a middle plate and a side frame. For example, the first middle frame 102a may include a first middle plate 1021 and a first side frame 1022, and the first side frame 1022 is disposed around an outer peripheral edge of the first middle plate 1021. The second middle frame 102b may also include a second middle plate 1023 and a second side frame 1024, and the second side frame 1024 is disposed around an outer peripheral edge of the second middle plate 1023. The rotating shaft 101 may be connected to the first middle plate 1021 and the second middle plate 1023. The middle plates may provide assembly place for the structural members, and improve strength of the middle frames.

The display 103 is disposed on the middle frame 102. For example, a part of the display 103 may be fastened to the side frame, and another part of the display 103 may be fastened to the middle plate.

It should be noted that the middle plate and the side frame may be separately formed, and the middle plate and the side frame may be fixedly assembled together through welding, snap-fit connection, bonding, or the like. Alternatively, the middle plate and the side frame may be integrally formed.

The electronic device 100 may further include a main circuit board, a battery, a charging management module, a power management module, and the like (not shown in the figure). The main circuit board, the battery, the charging management module, the power management module, and the like may be fastened in the accommodation space.

The main circuit board may be configured to implement electrical connection or electrical insulation between electronic components in the electronic device. For example, the main circuit board may include a processor. The processor may include an application processor (application processor, AP for short), a modem processor, a graphics processing unit (graphics processing unit, GPU for short), an image signal processor (image signal processor, ISP for short), a controller, a video codec, a digital signal processor (digital signal processor, DSP for short), a baseband processor, a display processing unit (display processing unit, DPU for short), a neural-network processing unit (neural-network processing unit, NPU for short), and/or the like. The controller may be a nerve center and a command center of the electronic device 100. The controller may generate an operation control signal based on instruction operation code and a timing signal, to complete control of instruction fetching and instruction execution. A memory may be further disposed in the processor to store instructions and data.

The processor may include one or more interfaces. The interface may be configured to connect to a charger to charge the electronic device 100, and the interface may also be configured to implement data transmission between the electronic device 100 and an external device. For example, the interface may also be configured to connect to a headset, a projection apparatus, or the like.

The charging management module is configured to receive a charging input from a charger. The charger may be a wireless charger or a wired charger. In some wired charging examples, the charging management module may receive a charging input of a wired charger through the interface. In some wireless charging embodiments, the charging management module may receive a wireless charging input through a wireless charging coil of the electronic device 100. The charging management module can charge the battery, and may further supply power to the electronic device 100 by using the power management module.

The power management module is configured to connect to the battery, the charging management module, and the processor. The power management module receives an input of the battery and/or the charging management module, to supply power to the processor, the memory, a display, a camera module, and the like. The power management module may be further configured to monitor parameters such as a battery capacity, a quantity of battery cycles, and a battery health status (electric leakage or impedance).

In some examples, the power management module may be disposed in the processor of the main circuit board. In some other examples, the power management module and the charging management module may alternatively be disposed in a same component.

The first middle frame 102a, a part of the rear cover 104, and a part of the display 103 may enclose an accommodation cavity, and the second middle frame 102b, a part of the rear cover 104, and a part of the display 103 may enclose another accommodation cavity. Both the accommodation cavities may be configured to accommodate electronic components such as the main circuit board, the battery, the power management module, and the charging management module. In some examples, the electronic device may include two main circuit boards. One main circuit board may be located in the first middle frame 102a, to implement electrical connection or electrical insulation between electronic components in the first middle frame 102a. The other main circuit board may be located in the second middle frame 102b, to implement electrical connection or electrical insulation between electronic components in the second middle frame 102b.

The electronic device further includes a cross-shaft circuit board (not shown in the figure), and the cross-shaft circuit board is configured to implement electrical connection between the electronic components located in the accommodation cavities enclosed by the two middle frames. For example, the rotating shaft may be provided with a cross-shaft hole, and the cross-shaft circuit board may be disposed through the cross-shaft hole, so that one end of the cross-shaft circuit board may be located in the accommodation cavity enclosed by the first middle frame, and the other end of the cross-shaft circuit board may pass through the cross-shaft hole and be located in the accommodation cavity enclosed by the second middle frame, to implement electrical connection between the electronic components in the two middle frames.

It may be understood that the cross-shaft circuit board is a flexible circuit board. When the first middle frame 102a and the second middle frame 102b rotate relative to each other to fold or unfold, the cross-shaft circuit board may bend as the first middle frame 102a and the second middle frame 102b rotate.

The structure shown in embodiments of this application does not constitute a specific limitation on the electronic device 100. In some other embodiments of this application, the electronic device 100 may include more or fewer components than those shown in the figure, or some components may be combined, or some components may be split, or different component arrangements may be used. For example, the electronic device 100 may further include components such as a communication module, a camera module (for example, a front-facing camera and a rear-facing camera), a microphone, a speaker, and a flash.

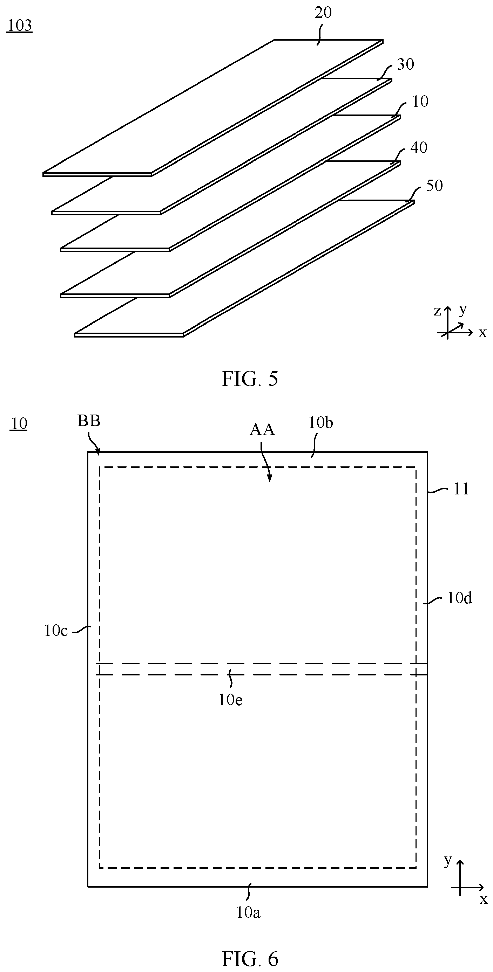

FIG. 5 is a diagram of a split structure of a display in FIG. 4.

As shown in FIG. 5, the display 103 includes a display panel 10 and a cover 20. The display panel 10 is configured to implement functions such as displaying of the display 103. A length direction, a width direction, and a thickness direction of the display panel 10 may be respectively consistent with the length direction, the width direction, and the thickness direction of the middle frame 102, for example, respectively consistent with the y direction, the x direction, and the z direction in FIG. 5.

The cover 20 may be of a light-transmitting plate-shaped structure. For example, the cover 20 may be a transparent glass plate. The cover 20 covers one side of the display panel 10. For example, in the thickness direction of the electronic device 100, the cover 20 may be disposed on a side that is of the display panel 10 and that backs on the middle plate (or the rear cover), and the cover 20 may cover a side that is of the display panel 10 and that backs on the middle plate. The cover 20 protects the display panel 10. For example, a size of the cover 20 may be greater than or equal to a size of the display panel 10.

The display 103 may further include a polarizer 30. The polarizer 30 may be disposed between the cover 20 and the display panel 10. The polarizer 30 may selectively filter out light in some directions and allow light in a specific direction to pass through. The polarizer 30 can adjust a propagation direction of light, adjust display brightness, contrast, and the like, and can further reduce reflection and glare, to improve visual clarity.

For example, the polarizer 30 and the cover 20 may be fixedly assembled through bonding. For example, there may be an optical adhesive layer (not shown in the figure) between the cover 20 and the polarizer 30. The optical adhesive layer may be an adhesive layer formed by an optical clear adhesive (optical clear adhesive, OCA) or the like. The cover 20 and the polarizer 30 are bonded and fastened together via the optical adhesive layer.

The polarizer 30 and the display panel 10 may also be fixedly assembled through bonding. For example, there may also be an optical adhesive layer between the polarizer 30 and the display panel 10, so that the polarizer 30 and the display panel 10 may be bonded and fastened together via the optical adhesive layer.

Certainly, in some other examples, the cover 20 may alternatively be fixedly attached to the polarizer 30 in another manner, and the polarizer 30 may alternatively be fixedly attached to the display panel 10 in another manner. For example, the cover 20, the polarizer 30, and the display panel 10 may be fixedly attached through hot pressing.

The display 103 may further include a protective film 40 and a support film 50. The protective film 40 and the support film 50 may be sequentially stacked on a side that is of the display panel 10 and that backs on the cover 20. In other words, the cover 20, the polarizer 30, the display panel 10, the protective film 40, and the support film 50 may be sequentially stacked in the thickness direction. The protective film 40 may cover a surface that is of the display panel 10 and that backs on the cover 20, and the protective film 40 protects the display panel 10. The support film 50 can enhance support for the display panel 10, to improve strength of the entire display 103.

For example, the protective film 40 and the display panel 10 may be fixedly assembled through bonding. For example, there may be a pressure-sensitive adhesive layer between the protective film 40 and the display panel 10. The pressure-sensitive adhesive layer may be an adhesive layer formed by a pressure-sensitive adhesive (pressure sensitive adhesive, PSA for short), and the protective film 40 and the display panel 10 may be bonded and fastened together via the pressure-sensitive adhesive layer.

The protective film 40 and the support film 50 may also be fixedly assembled through bonding. For example, there may also be a pressure-sensitive adhesive layer between the protective film 40 and the support film 50, so that the protective film 40 and the support film 50 may be bonded and fastened together via the pressure-sensitive adhesive layer.

FIG. 6 is a front view of a display panel in FIG. 5.

As shown in FIG. 6, the display panel 10 may include a display area AA and a peripheral area BB, and an image and the like may be displayed in the display area AA. The peripheral area BB may surround the display area AA. For example, a contour shape of the display area AA may be a rectangle, and a contour shape of the peripheral area BB may be a square ring, surrounding the display area AA. The peripheral area BB may be a non-display area, that is, the peripheral area BB may not be used for displaying an image.

For example, the peripheral area BB may include a first peripheral area 10c, a second peripheral area 10a, a third peripheral area 10b, and a fourth peripheral area 10d. For example, in a first direction, the first peripheral area 10c and the fourth peripheral area 10d may be located outside two sides of the display area AA, and in a second direction, the second peripheral area 10a and the third peripheral area 10b may be located outside two sides of the display area AA. The first direction intersects the second direction, for example, the first direction may be perpendicular to the second direction. For example, the first direction may be the same as the width direction (for example, the x direction in the figure) of the display panel, and the second direction may be the same as the length direction (for example, the y direction in the figure) of the display panel, so that the second peripheral area 10a, the third peripheral area 10b, the first peripheral area 10c, and the fourth peripheral area 10d enclose a ring area surrounding the display area AA.

Certainly, in some examples, the first direction may be the same as the length direction of the display panel, and the second direction may be the same as the width direction of the display panel. The first direction and the second direction may be set based on specific design requirements of the display panel.

The display panel 10 may further have a bent area 10e. The bent area 10e of the display panel 10 and a bent area 103a of the display 103 in the electronic device may approximately overlap in the thickness direction of the display. An extension direction of the bent area 10e is the same as an axial direction of the rotating shaft of the electronic device.

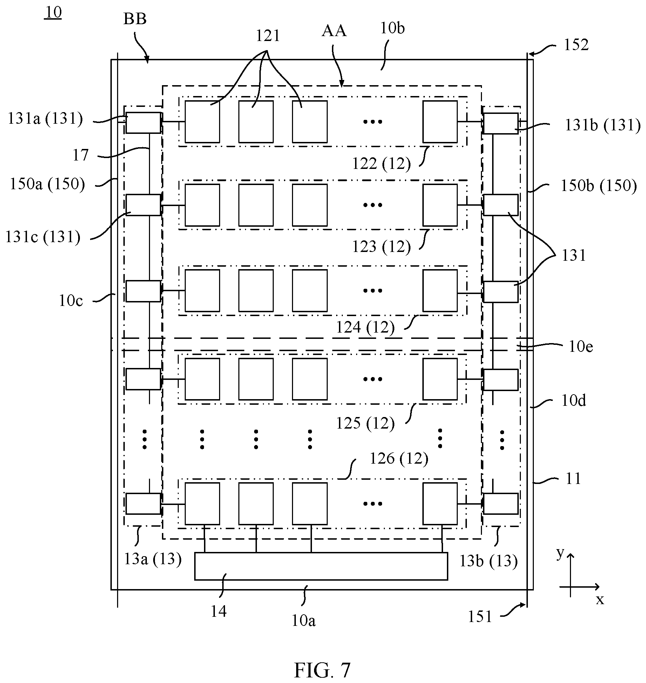

FIG. 7 is a diagram of a structure of a display panel in FIG. 6.

As shown in FIG. 7, the display panel 10 may include a substrate 11 and a plurality of pixel groups 12. The substrate 11 may be used as a main bearing structure of the display panel 10. The substrate 11 may include a first surface and a second surface that back on each other (not shown in the figure). For example, the first surface and the second surface may back on each other in the thickness direction. For example, the first surface may be divided into the display area AA and the peripheral area BB.

The plurality of pixel groups 12 are also disposed on the substrate 11, for example, the plurality of pixel groups 12 are also located on the first surface of the substrate 11, and the plurality of pixel groups 12 are located in the display area AA. The plurality of pixel groups 12 may be sequentially arranged in the second direction (y direction). As shown in FIG. 7, for example, a quantity of pixel groups 12 is n, and n is greater than 1. For example, the n pixel groups 12 may be: a first pixel group 122, a second pixel group 123, a third pixel group 124, a fourth pixel group 125, ..., and an n^{th} pixel group 126. The first pixel group 122, the second pixel group 123, the third pixel group 124, the fourth pixel group 125, ..., and the n^{th} pixel group 126 are sequentially arranged in the second direction (y direction). For example, the first pixel group 122 may be closer to the third peripheral area 10b, and the n^{th} pixel group 126 may be closer to the second peripheral area 10a.

Each pixel group 12 may include a plurality of pixel units 121, and the pixel units 121 may be used as main light-emitting units of the display panel 10, and can generate light. For example, the plurality of pixel units 121 may generate three primary colors: red (red), green (green), and blue (blue), that is, form a primary color mode (RGB color model, RGB mode for short), to form colors and implement display.

The plurality of pixel units 121 in each pixel group 12 may be sequentially arranged in one row along the first direction (x direction), and distribution locations of a plurality of pixel units 121 in any two pixel groups 12 may be in a one-to-one correspondence along the second direction, so that a plurality of pixel units 121 in the display area AA may form an array arranged in a crosswise manner along the second direction and the first direction.

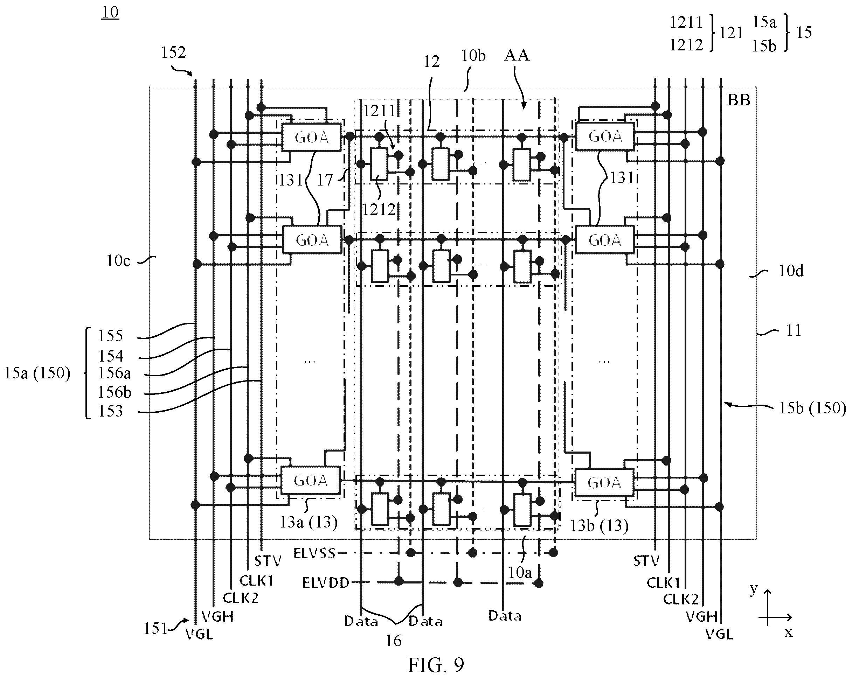

Each pixel unit 121 may include a pixel circuit 1211 and a subpixel 1212 (refer to FIG. 9), and the subpixel 1212 may be an organic light-emitting diode. For example, the plurality of subpixels 1212 of the plurality of pixel units 121 may include a plurality of red pixels, a plurality of green pixels, and a plurality of blue pixels, and the red pixels, the green pixels, and the blue pixels may respectively emit red light, green light, and blue light.

The pixel circuit 1211 is electrically connected to the subpixel 1212, and the pixel circuit 1211 can drive and control the subpixel 1212 to emit light and turn off, so that the display panel 10 can display an image and the like.

The pixel circuit 1211 may include one or more thin film transistors (thin film transistor, TFT for short) (not shown in the figure). The thin film transistor is a field effect transistor, and the thin film transistor includes three electrodes: a source (source), a gate (gate), and a drain (drain). A gate drive signal input from the gate may be used to control turning on and off of the thin film transistor, to control turning on/off of the organic light-emitting diode, so as to drive and control the subpixel 1212 to emit light and turn off.

Still refer to FIG. 7. The display panel 10 further includes gate drive circuits 131 and a source drive circuit 14. The gate drive circuit 131 is configured to provide a gate drive signal for the pixel circuit 1211, and the source drive circuit 14 is configured to provide a source drive signal for the pixel circuit 1211. The gate drive circuits 131 and the source drive circuit 14 may also be located on the first surface of the substrate 11, and are located in the peripheral area BB. For example, the gate drive circuit 131 may be located in the peripheral area BB outside one side of the display area AA along the first direction. For example, the gate drive circuits 131 may be located in the first peripheral area 10c and the fourth peripheral area 10d. The source drive circuit 14 may be located in the peripheral area BB outside one side of the display area AA along the second direction, for example, the source drive circuit 14 may be located in the second peripheral area 10a.

For example, the gate drive circuits 131 may be integrated on the substrate 11 by using a gate driver on array technology (GOA technology). The gate drive circuit 131 may include a plurality of cascading shift registers (shift register, SR for short), and may implement functions such as data register, serial-to-parallel conversion of data, and data operation and processing.

There may be a plurality of gate drive circuits 131. For example, the display panel 10 may include several drive circuit groups 13, and each drive circuit group 13 may include a plurality of gate drive circuits 131. A quantity of gate drive circuits 131 in each drive circuit group 13 may be the same as a quantity of pixel groups 12, and one gate drive circuit 131 in each drive circuit group 13 is correspondingly connected to one pixel group 12, to provide a gate drive signal for the plurality of pixel units 121 in the pixel group 12. For example, the gate drive circuits 131 in each drive circuit group 13 may alternatively be sequentially arranged in the second direction, and the gate drive circuits 131 and the pixel units 121 connected to the gate drive circuits 131 may be distributed in the first direction. In each gate drive circuit group 13, two adjacent gate drive circuits 131 may be connected through a connection line 17 (as shown in FIG. 9), that is, the plurality of gate drive circuits 131 sequentially arranged in the second direction are sequentially connected, so that the plurality of gate drive circuits drive the plurality of pixel groups 12 row by row.

For example, the drive circuit groups 13 may be distributed in the peripheral area BB outside two opposite sides of the display area AA along the first direction. For example, the display panel 10 may include a plurality of drive circuit groups 13, and the plurality of drive circuit groups 13 may be symmetrically distributed in the peripheral area BB outside the two opposite sides of the display area AA along the first direction. In other words, the plurality of drive circuit groups 13 may be evenly (for example, quantities of drive circuit groups 13 distributed in the two peripheral areas are equal) distributed in the first peripheral area 10c and the fourth peripheral area 10d. One gate drive circuit 131 in each drive circuit group 13 is correspondingly connected to one pixel group 12. In the first direction, at least one gate drive circuit 131 can be connected to each of two sides of one pixel group 12, and the gate drive circuits 131 on the two sides of the pixel group 12 can simultaneously provide a gate control signal for the pixel units 121 in the pixel group 12, to drive and control the pixel units 121 to emit light and turn off, help improve uniformity of luminance of the pixel units 121, and improve display effect.

For example, as shown in FIG. 7, the display panel 10 may include two drive circuit groups 13: a drive circuit group 13a and a drive circuit group 13b. The drive circuit group 13a and the drive circuit group 13b may be respectively located in the first peripheral area 10c and the fourth peripheral area 10d. A plurality of gate drive circuits 131 in the drive circuit group 13a may be sequentially arranged in the second direction, and one gate drive circuit 131 is connected to one pixel group 12. A plurality of gate drive circuits 131 in the drive circuit group 13b may be sequentially arranged in the second direction, and one gate drive circuit 131 is connected to one pixel group 12.

The first pixel group 122 is used as an example. In the first direction, two sides of the first pixel group 122 are respectively connected to two gate drive circuits 131, for example, a gate drive circuit 131a in the drive circuit group 13a and a gate drive circuit 131b in the drive circuit group 13b. The gate drive circuit 131a and the gate drive circuit 131b may simultaneously provide gate drive signals for pixel circuits in the first pixel group 122, to implement drive and control on pixel units 121 in the first pixel group 122.

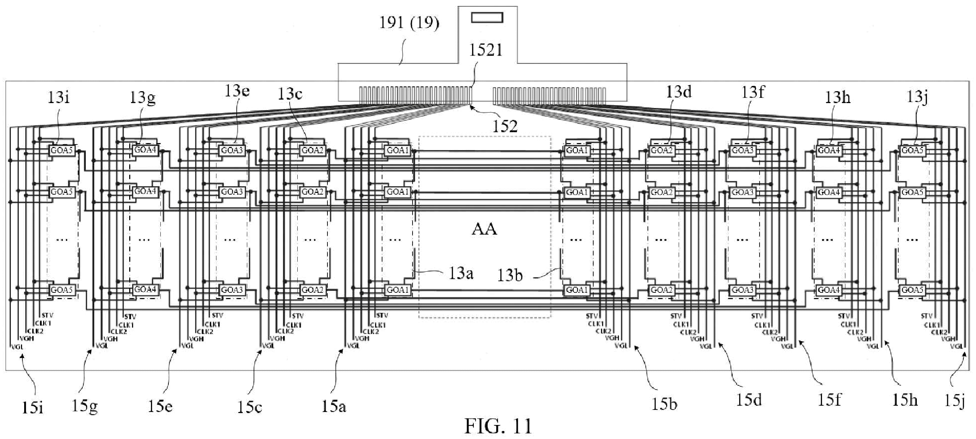

Certainly, in some examples, the display panel 10 may alternatively include more than two drive circuit groups 13 (refer to FIG. 11). A quantity of drive circuit groups 13 may be an even number. For example, the plurality of drive circuit groups 13 are evenly distributed in the first peripheral area 10c and the fourth peripheral area 10d, so that a plurality of drive circuit groups 13 are distributed in the first peripheral area 10c, and a plurality of drive circuit groups 13 are distributed in the fourth peripheral area 10d.

Alternatively, in some examples, the drive circuit groups 13 may be located in the peripheral area BB outside only one side of the display area AA along the first direction, for example, in either the first peripheral area 10c or the fourth peripheral area 10d.

Still refer to FIG. 7. The display panel 10 may further include a gate control line 150. The gate control line 150 may be located on the first surface of the substrate 11, the gate control line is configured to transmit a gate control signal, the gate control line is connected to the gate drive circuit, and the gate drive circuit may output a gate drive signal based on the gate control signal. One drive circuit group is connected to at least one gate control line 150, and each gate control line 150 is electrically connected to at least one gate drive circuit 131 in the drive circuit group 13, to further connect to pixel units 121 in at least one pixel group 12. A power supply chip of the electronic device is electrically connected to the gate control line 150, and the power supply chip may output a gate control signal. The gate control signal is transmitted to the gate control line 150, and then transmitted to the gate drive circuit 131 through the gate control line 150, to implement drive and control on the pixel units 121 in the plurality of pixel groups 12.

The gate control signal output by the power supply chip may include a start signal (start voltage, STV for short), a gate high voltage signal (voltage gate high, VGH for short), a gate low voltage signal (voltage gate low, VGL for short), a timing signal (clock, CLK for short), and the like.

The start signal may be used as a start input signal, or may be used as an initial input voltage.

The gate high voltage signal is a positive source voltage that needs to be input to the gate drive circuit, and the gate low voltage signal is a negative source voltage that needs to be input to the gate drive circuit. The gate high voltage signal or the gate low voltage signal may be used as a gate turn-on voltage or a gate turn-off voltage of the thin film transistor. For different thin film transistors, the gate high voltage signal and the gate low voltage signal may correspond to different gate turn-on or turn-off functions. For example, for a thin film transistor with an n-type substrate and a p-channel metal oxide semiconductor (positive channel metal oxide semiconductor, PMOS for short), the gate low voltage signal is a gate turn-on voltage, and the gate high voltage signal is a gate turn-off voltage. For example, for a thin film transistor with an N-type metal oxide semiconductor (n metal oxide semiconductor, NPOMS for short), the gate high voltage signal is a gate turn-on voltage, and the gate low voltage signal is a gate turn-off voltage.

The timing signal is used to implement timing control on light emitting and turning off of the pixel units in each pixel group.

The display panel may include a start signal line, a gate high voltage signal line, a gate low voltage signal line, a clock signal line, and the like. The start signal line, the gate high voltage signal line, the gate low voltage signal line, and the clock signal line are respectively configured to transmit the start signal, the gate high voltage signal, the gate low voltage signal, and the timing signal. The start signal line, the gate high voltage signal line, the gate low voltage signal line, the clock signal line, and the like may all be used as gate control lines 150 of the display panel 10, and are configured to transmit a gate control signal to the gate drive circuits 131, to drive and control the pixel units 121.

Certainly, in some other examples, the power supply chip may alternatively output another type of gate control signal, and the display panel may correspondingly include another type of gate control line.

For example, each gate drive circuit in one drive circuit group is connected to the gate control lines 150 such as the gate high voltage signal line, the gate low voltage signal line, and the clock signal line, and then connected to the power supply chip. The gate high voltage signal, the gate low voltage signal, the clock signal, and the like that are output by the power supply chip are transmitted through the gate control lines 150 and are sequentially transmitted to the gate drive circuits 131 and pixel groups 12 correspondingly connected to the gate drive circuits 131.

In one drive circuit group, the plurality of gate drive circuits 131 are sequentially arranged in one column along the second direction. A gate drive circuit closest to the second peripheral area or the third peripheral area may be connected to the power supply chip through the start signal line, to drive the pixel units 121 in the plurality of pixel groups 12 to emit light or turn off row by row.

Refer to FIG. 7. The drive circuit group 13a is used as an example to describe row-by-row driving and controlling on the pixel units 121 in the plurality of pixel groups 12. Driving and controlling on pixel units by remaining drive circuit groups in the plurality of drive circuit groups may be deduced by analogy.

For example, the gate control line 150 is a start signal line. The gate control signal output by the power supply chip includes a start signal. The power supply chip may be connected, through the gate control line 150, to a gate drive circuit 131a that is in the drive circuit group 13a and that is closest to the third peripheral area 10b, the start signal output by the power supply chip may be transmitted to the gate drive circuit 131a through the gate control line 150, and the gate drive circuit 131a outputs a gate drive signal. The gate drive signal may be used to drive light emitting or turning off of the pixel units 121 in the first pixel group 122 correspondingly connected to the gate drive circuit 131a. The gate drive signal may also be used as a start signal of a next row of pixel units (a next pixel group in the second direction), and is transmitted to the gate drive circuit 131c through the connection line 17, so that the gate drive circuit 131c drives and controls light emitting or turning off of pixel units in the second pixel group 123 correspondingly connected to the gate drive circuit 131c. The rest can be deduced by analogy. A pixel group closest to the third peripheral area 10b to a pixel group closest to the second peripheral area 10a are sequentially driven and controlled row by row, to drive and control the pixel units 121 in the plurality of pixel groups 12 to emit light or turn off row by row.

Certainly, in some examples, the power supply chip may be connected, through the gate control line 150, to a gate drive circuit that is in the drive circuit group 13a and that is closest to the second peripheral area 10a. In other words, the pixel group closest to the second peripheral area 10a to the pixel group closest to the third peripheral area 10b are sequentially driven and controlled row by row.

The display may further include a drive chip (not shown in the figure), and the power supply chip may be electrically connected to the drive chip. The drive chip may be electrically connected to the gate control line 15, and the drive chip may implement boost processing and the like on the gate control signal, so that the gate control signal can meet a voltage range requirement of the gate drive circuit 131. This ensures drive effect.

For example, power supply chips may be distributed outside the substrate 11 of the display panel 10, and drive chips may be integrated on the first surface of the substrate 11 of the display panel.

Alternatively, in some examples, the display may not include the drive chip, and a boost circuit and the like may be integrated into the power supply chip; or a boost circuit and the like may be integrated on the substrate 11 of the display panel 10, so that boost processing and the like on the gate control signal output by the power supply chip may be implemented by the boost circuit and the like.

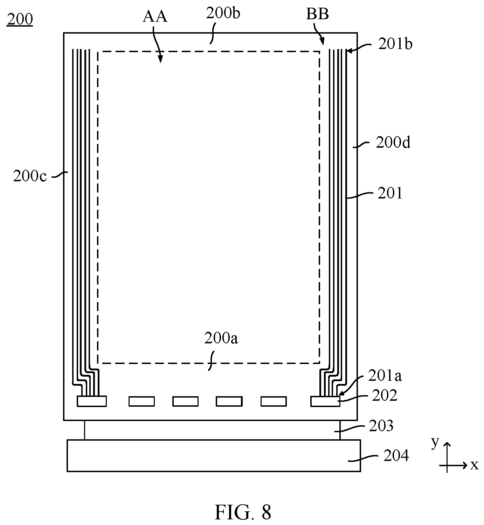

FIG. 8 is a diagram of tracing of a gate control line in an electronic device in a related technology. To implement electrical connection between the power supply chip (or the drive chip) and the gate drive circuit, as shown in FIG. 8, drive chips 202 are usually located in a bottom peripheral area 200a on one side of the display area AA. The power supply chips (not shown in the figure) may be integrated on a first circuit board 204, and the first circuit board 204 may be disposed adjacent to the drive chips 202 and the bottom peripheral area 200a. The power supply chip may be electrically connected to the drive chip 202 and the first circuit board 204 via a second circuit board 203.

The gate control lines 201 are located in the peripheral area BB. For example, a left peripheral area 200c and a right peripheral area 200d each have drive circuit groups (not shown in the figure) and the gate control lines 201. The gate control line 201 may include a first end 201a and a second end 201b. The first end 201a of the gate control line 201 may be located in the bottom peripheral area 200a and electrically connected to the drive chip 202 in the bottom peripheral area 200a. The second end of the gate control line 201 extends towards a top peripheral area 200b, and is electrically connected to the gate drive circuit in the drive circuit group, so that the gate control line 201 can be electrically connected to the pixel units in the pixel group via the gate drive circuit. Therefore, the drive chip 202 (or the power supply chip) is electrically connected to the pixel units in the pixel group. Second ends 201b of the gate control lines 201 may extend to two sides of a row of pixel units closest to the top peripheral area 200b.

For example, the gate control line 201 is a gate low voltage signal line. Gate low voltage signals on which the drive chips 202 perform boosting processing are input from first ends 201a of the gate control lines 201, transmitted through the gate control lines 201 to the second ends 201b, and sequentially transmitted to the plurality of gate drive circuits, to drive the pixel units in the plurality of pixel groups to emit light or turn off. In other words, the gate control signal is transmitted from the first ends 201a of the gate control lines 201 to the second ends 201b, and transmitted to the gate drive circuits.

As users continuously require a larger display size of an electronic device, electronic devices with a larger display size are widely popular, for example, a foldable electronic device with a large display size in an unfolded state. As the size of the display increases, a size of the display panel also increases, and a length of a trace of the gate control line is long.

Therefore, the gate control signal is introduced from the first end of the gate control line, and transmitted to the gate drive circuit, to drive the pixel units in the plurality of pixel groups row by row. During transmission on the gate control line, tracing impedance is large, a voltage of the gate control signal transmitted to the gate drive circuit severely attenuates, and a resistive-capacitive delay is large. It can be understood that, a longer path for transmission on the gate control line (a longer distance from the introduction end) indicates severer voltage attenuation. For example, in comparison with the gate low voltage signal transmitted to the gate drive circuit closest to the first end, a voltage of the gate low voltage signal transmitted to the gate drive circuit closest to the second end is low due to voltage attenuation caused by the tracing impedance. Consequently, drive effect of the gate drive circuit on correspondingly connected pixel units is affected, and display uniformity is further affected.

In view of this, embodiments of this application provide a display panel and a display. A gate control line is disposed in at least a first peripheral area, a plurality of pixel groups are sequentially distributed in a display area, and the gate control line is connected to pixel units in the pixel group via a gate drive circuit. A gate control signal transmitted by the gate control line may be transmitted to gate drive circuits, to drive and control pixel units in the plurality of pixel groups to emit light or turn off. A first end and a second end of the gate control line are electrically connected to a power supply chip of an electronic device. The gate control signal output by the power supply chip may be separately introduced from the first end and the second end into the gate control line, so that the gate control signal is introduced from two opposite ends of the gate control line for simultaneous driving. The gate control signal is introduced from the first end and transmitted to the gate drive circuit, and consequently, voltage attenuation occurs in the gate control signal. Voltage attenuation also occurs in the gate control signal that is introduced from the second end and transmitted to the gate drive circuit along the gate control line. However, the two parts of the gate control signal are superimposed for simultaneous driving, to ensure that a voltage of a gate control signal input into each gate drive circuit is high. This reduces voltage attenuation of the gate control signal transmitted to the gate drive circuit and a resistive-capacitive delay, improves a drive capability, improves drive uniformity and drive effect on the plurality of pixel groups, and further improves display effect and display uniformity of the display panel.

FIG. 9 is a diagram of a circuit connection structure of pixel units, gate drive circuits, and gate control lines in the display panel in FIG. 7.

In the display panel provided in embodiments of this application, in the first direction (x direction), the gate control line is disposed in at least one of two peripheral areas located outside two sides of the display area, for example, the gate control line is disposed in at least the first peripheral area.

It may be understood that the gate control line and the gate drive circuit may be located in a same peripheral area, so that the gate control line is electrically connected to the gate drive circuit.

For example, in the first direction, gate drive circuits (drive circuit groups) are respectively disposed in peripheral areas outside the two sides of the display area, and gate control lines may be respectively disposed in the peripheral areas outside the two sides. For example, as shown in FIG. 9, gate drive circuits 131 are respectively disposed in the first peripheral area 10c and the fourth peripheral area 10d. The gate control lines 150 may be respectively distributed in the first peripheral area 10c and the fourth peripheral area 10d, and the gate drive circuits 131 in the first peripheral area 10c and the gate drive circuits 131 in the fourth peripheral area 10d are respectively connected to the gate control lines 150.

If the gate drive circuits 131 are disposed in the peripheral area BB outside only one side of the display area AA, the gate control lines 150 may also be disposed only in the peripheral area BB. If the gate drive circuits 131 are disposed in the first peripheral area 10c, the first peripheral area 10c has the gate control lines 150.

At least one of the gate control lines 150 is a gate control line 15. For example, as shown in FIG. 9, gate control lines 150 connected to the drive circuit group 13a may all be gate control lines 15, for example, a start signal line 153, a gate high voltage signal line 154, a gate low voltage signal line 155, a clock signal line 156a, and a clock signal line 156b are all gate control lines 15.

The gate control lines 15 may extend in the second direction (y direction), so that the gate control lines 15 can be connected to one or more gate drive circuits 131 in the drive circuit group 13 that are arranged in the second direction, and then connected to pixel units 121 in at least one pixel group 12. At least a part of the gate control line 15 is located in the peripheral area BB, that is, the gate control line 15 may be completely located in the peripheral area BB, or the gate control line 15 may partially extend out of the peripheral area BB in the second direction.

The gate control line 15 may include a first end 151 and a second end 152 that are opposite to each other in the second direction. For example, the first end 151 may be disposed adjacent to the second peripheral area 10a, and the second end 152 may be disposed adjacent to the third peripheral area 10b.

The first end 151 and the second end 152 of the gate control line 15 are electrically connected to the power supply chip (or the drive chip). The gate control signal output by the power supply chip may be separately transmitted from the first end 151 and the second end 152 to the gate control line 15, that is, the gate control signal can be input to both the first end 151 and the second end 152 of the gate control line 15. The gate control signal may be introduced into the gate control line 15 from the first end 151, transmitted along the gate control line 15 to the second end 152, and transmitted to the gate drive circuit 131, to drive the pixel units 121 in the plurality of pixel groups 12 row by row. Alternatively, the gate control signal may be introduced into the gate control line 15 from the second end 152, transmitted along the gate control line 15 to the first end 151, and transmitted to the gate drive circuit 131, to drive the pixel units 121 in the plurality of pixel groups 12 row by row.

In this case, the gate control signal is introduced from two opposite ends of the gate control line 15 for simultaneous driving, and the gate control signal is introduced from the first end 151 and transmitted to the gate drive circuit 131. Consequently, voltage attenuation occurs in the gate control signal, that is, voltage attenuation occurs in a process of transmitting the gate control signal from the first end 151 to the second end 152. Voltage attenuation also occurs in the gate control signal that is introduced from the second end 152 and transmitted to the gate drive circuit 131 along the gate control line 15. However, the two parts of the gate control signal are superimposed for simultaneous driving, to ensure that a voltage of a gate control signal input into each gate drive circuit 131 is high. This reduces voltage attenuation of the gate control signal transmitted to the gate drive circuit (or the pixel units) and a resistive-capacitive delay, improves a drive capability, improves drive uniformity and drive effect on the plurality of pixel groups 12, and further improves display effect and display uniformity of the display panel 10. This also helps reduce drive power consumption while ensuring display effect of the display.

It should be noted that the gate control signal is input from the first end 151 and the second end 152 to the gate control line 15 and transmitted to one or more gate drive circuits 131, to drive the pixel units 121 in the pixel group 12. The transmission processes may be synchronous. In other words, gate control signals introduced from the first end 151 and the second end 152 may be the same and are simultaneously transmitted to a same gate drive circuit 131, to drive pixel units 121 in a same pixel group 12 to emit light or turn off.

Certainly, in some examples, transmission processes in which the gate control signals introduced from the first end 151 and the second end 152 are respectively transmitted to one or more gate drive circuits 131 may be asynchronous. For example, the gate control signals introduced from the first end 151 and the second end 152 may be different, and may be transmitted to different gate drive circuits 131.

It may be understood that one drive circuit group 13 is electrically connected to the power supply chip via at least one gate control line 15. In an example in which the display panel 10 includes a plurality of drive circuit groups 13, each of the plurality of drive circuit groups 13 may be electrically connected to the power supply chip via at least one gate control line 15. For example, as shown in FIG. 9, the gate control line 15 may include gate control lines 15a and gate control lines 15b. Some gate control lines 15a may be located in the first peripheral area 10c, and the gate control lines 15a may be respectively connected to the power supply chip and a plurality of gate drive circuits 131 in the drive circuit group 13a located in the first peripheral area 10c. Some gate control lines 15b may be located in the fourth peripheral area 10d, and the gate control lines 15b may be respectively connected to the power supply chip and a plurality of gate drive circuits 131 in the drive circuit group 13b located in the fourth peripheral area 10d.

It should be noted that, in the example in which the display panel 10 includes the plurality of drive circuit groups 13, all gate control lines 150 of the display panel 10 may be the foregoing gate control lines 15. For example, the plurality of drive circuit groups 13 may be electrically connected to the power supply chip via the gate control lines 15 provided in this embodiment of this application. For example, as shown in FIG. 9, the drive circuit group 13a in the first peripheral area 10c and the drive circuit group 13b in the fourth peripheral area 10d are respectively electrically connected to the gate control lines 15.

Alternatively, some gate control lines 150 of the display panel 10 are the foregoing gate control lines 15, and some gate control lines 150 may be the foregoing gate control lines 201 in the conventional technology. For example, some of the plurality of drive circuit groups 13 may be electrically connected to the power supply chip via the gate control lines 15 provided in this embodiment of this application, and some of the plurality of drive circuit groups 13 may be electrically connected to the power supply chip via the gate control lines 201 in the conventional technology. For example, the drive circuit group 13 in the first peripheral area 10c may be electrically connected to the power supply chip via the gate control lines 15 provided in this embodiment of this application, and the drive circuit group 13 in the fourth peripheral area 10d may be electrically connected to the power supply chip via the gate control lines 201 in the conventional technology. Alternatively, in the first peripheral area 10c, some drive circuit groups 13 may be electrically connected to the power supply chip via the gate control lines 15 provided in this embodiment of this application, and some drive circuit groups 13 may be electrically connected to the power supply chip via the gate control lines 201 in the conventional technology. In the fourth peripheral area 10d, some drive circuit groups 13 may be electrically connected to the power supply chip via the gate control lines 15 provided in this embodiment of this application, and some drive circuit groups 13 may be electrically connected to the power supply chip via the gate control lines 201 in the conventional technology.

Alternatively, in some examples, in the plurality of gate control lines 150 correspondingly connected to one drive circuit group, the start signal line, the gate high voltage signal line, the gate low voltage signal line, the clock signal line, and the like may be the gate control lines 15 provided in this embodiment of this application. In other words, two ends of each of the start signal line, the gate high voltage signal line, the gate low voltage signal line, the clock signal line, and the like in the second direction are electrically connected to the power supply chip, and control signals are introduced from two sides of the signal line.

Alternatively, in the plurality of gate control lines 150 correspondingly connected to one drive circuit group, some of the start signal line, the gate high voltage signal line, the gate low voltage signal line, and the clock signal line may be the gate control lines 15 provided in this embodiment of this application, and some may be the gate control lines 201 in the conventional technology.

For example, as shown in FIG. 9, the gate high voltage signal line 154 and the gate low voltage signal line 155 of the display panel 10 may be the gate control lines 15 provided in this embodiment of this application. Two ends of the gate high voltage signal line may extend out of the substrate 11 and are electrically connected to the power supply chip, and gate high voltage signals may be respectively introduced from the two ends into the gate high voltage signal line 154, and then sequentially transmitted to the plurality of gate drive circuits 131.

The first end 151 and the second end 152 of the gate low voltage signal line 155 may also extend out of the substrate 11, and are electrically connected to the power supply chip, and gate low voltage signals may be respectively introduced from the first end 151 and the second end 152 to the gate low voltage signal line 155, and then sequentially transmitted to the plurality of gate drive circuits 131.

Alternatively, in some examples, the start signal line, the gate high voltage signal line, the gate low voltage signal line, and the clock signal line may all be the gate control lines 15 provided in this embodiment of this application. As shown in FIG. 9, each gate drive circuit 131 in one drive circuit group is connected to a plurality of gate control lines 15, and the plurality of gate control lines 15 may be the start signal line 153, the gate high voltage signal line 154, the gate low voltage signal line 155, the clock signal line 156a, and the clock signal line 156b.

Still refer to FIG. 9. To facilitate electrical connection between the first end and the second end of the gate control line 15 and the power supply chip, the first end 151 of the gate control line 15 may extend out of a side that is of the second peripheral area 10a and that backs on the display area AA, and the second end 152 of the gate control line 15 may extend out of a side that is of the third peripheral area 10b and that backs on the display area AA. In other words, the first end 151 and the second end 152 of the gate control line 15 may extend outside the substrate 11 of the display panel 10, to facilitate electrical connection between the gate control line 15 and the power supply chip outside the substrate 11. Boost circuits may be respectively disposed between the power supply chip and the first end 151 of the gate control line 15 and between the power supply chip and the second end 152 of the gate control line 15.

As shown in FIG. 9, the display panel 10 may further include a plurality of data lines (data line) 16. The plurality of data lines 16 may be distributed in the first direction, and each data line 16 is correspondingly connected to one pixel unit 121 in the plurality of pixel groups 12. The data line 16 may be electrically connected to a source of the thin film transistor, and is configured to output a voltage signal Vdata.

The electronic device may further include a high-level power supply and a low-level power supply (not shown in the figure). The high-level power supply is configured to provide a high-level voltage (ELVSS), the low-level power supply is configured to provide a low-level voltage (ELVDD), and ELVDD and ELVSS are used to provide power supply signals for light-emitting diodes in the pixel units 121 in the entire display surface.

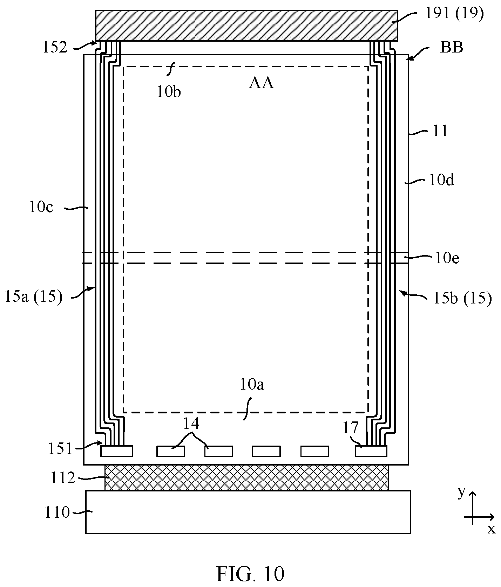

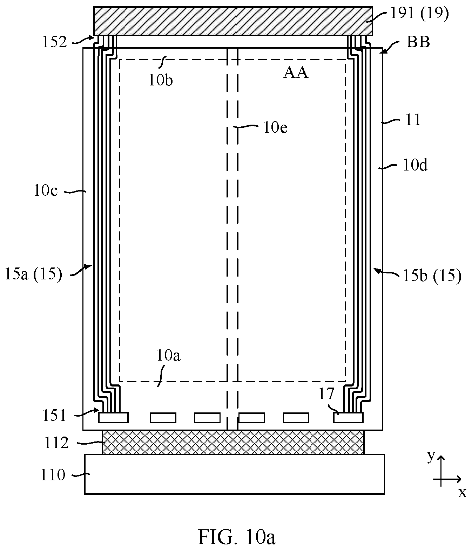

FIG. 10 is another diagram of tracing of a gate control line of a display in an electronic device according to this application.

Alternatively, in an example in which the display includes a drive chip, as shown in FIG. 10, a drive chip 17 may be located in the second peripheral area 10a, and the first end 151 of the gate control line 15 may also be located in the second peripheral area 10a and electrically connected to the drive chip 17.

Certainly, in some examples, the second end 152 of the gate control line 15 may alternatively be located in the third peripheral area 10b. For example, the drive chip 17 configured to implement boost processing and the like may alternatively be disposed in the third peripheral area 10b, so that the second end 152 of the gate control line 15 is electrically connected to the drive chip 17, and the drive chip 17 is electrically connected to the power supply chip.

It should be noted that FIG. 10 shows distribution of the gate control lines 15 of the displaying of the foldable electronic device. The extension direction of the bent area 10e may intersect with the extension direction of the gate control line 15. For example, as shown in FIG. 10, the extension direction of the gate control line 15 may be the second direction (y direction), and the extension direction of the bent area 10e may be the first direction (x direction).

FIG. 10a is still another diagram of tracing of a gate control line of a display in an electronic device according to an embodiment of this application.

Alternatively, in some examples, the extension direction of the bent area 10e may be the same as the extension direction of the gate control line 15. For example, as shown in FIG. 10a, both the extension direction of the gate control line 15 and the extension direction of the bent area 10e may be the second direction (y direction).

The following describes connection between the first end 151 and the second end 152 and the power supply chip by using an example in which the first end 151 of the gate control line 15 is located in the second peripheral area 10a, and the second end 152 of the gate control line 15 extends out of the side that is of the third peripheral area 10b and that backs on the display area AA (that is, outside the substrate 11).

It should be noted that an implementation in which the first end 151 of the gate control line 15 is connected to the power supply chip changes slightly, and feasibility is high when the first end 151 of the gate control line 15 is located in the second peripheral area 10a, the second end 152 extends outside the substrate 11, and the gate control signals are introduced from the two sides of the gate control line 15 for simultaneous driving. In addition, this helps reduce structural design difficulty and manufacturing costs.

With reference to FIG. 10 and FIG. 10a, the display further includes a first circuit board 19 and a second circuit board 112. The second end 152 of the gate control line 15 extends outside the substrate 11, and may be electrically connected to the first circuit board 19. The first circuit board 19 is electrically connected to the power supply chip (not shown in the figure), so that the second end 152 of the gate control line 15 is electrically connected to the power supply chip.

The electronic device may include a third circuit board 110. The power supply chip may be integrated on the third circuit board 110, and is electrically connected to the third circuit board 110. The first circuit board 19 may be electrically connected to the third circuit board 110.

The second circuit board 112 may be electrically connected to the drive chip 17 and the third circuit board 110, so that the first end of the gate control line 15 is electrically connected to the power supply chip on the third circuit board 110 via the drive chip 17 and the second circuit board 112. FIG. 11 is a diagram of a structure of connection between the gate control line in FIG. 10 and a first circuit board.

For example, as shown in FIG. 11, a first conductive pad 1521 may be disposed on the second end 152 of the gate control line 15.

A second conductive pad (not shown in the figure) may be disposed on the first circuit board 19. The first conductive pad 1521 and the second conductive pad may be any conductive structural member that can implement electrical connection, for example, may be a conductive structural member made of a metal material, for example, a bonding pad (bonding pad); or a conductive structural member made of a non-metal conductive material.

The first conductive pad 1521 is in conductive contact with the second conductive pad, so that the second end 152 of the gate control line 15 can be electrically connected to the first circuit board 19. The structure design is simple and easy to implement.

It should be noted that, in the example in which the display panel 10 includes the plurality of drive circuit groups 13 and each drive circuit group 13 may be electrically connected to the power supply chip via the plurality of gate control lines 15, as shown in FIG. 11, for example, the plurality of drive circuit groups 13 are: the drive circuit group 13a, the drive circuit group 13b, a drive circuit group 13c, a drive circuit group 13d, a drive circuit group 13e, a drive circuit group 13f, a drive circuit group 13g, a drive circuit group 13h, a drive circuit group 13i, and a drive circuit group 13j. The drive circuit group 13a, the drive circuit group 13b, the drive circuit group 13c, the drive circuit group 13d, the drive circuit group 13e, the drive circuit group 13f, the drive circuit group 13g, the drive circuit group 13h, the drive circuit group 13i, and the drive circuit group 13j may be electrically connected to the first circuit board 19 via the gate control line 15a, the gate control line 15b, a gate control line 15c, a gate control line 15d, a gate control line 15e, a gate control line 15f, a gate control line 15g, a gate control line 15h, a gate control line 15i, and a gate control line 15j, respectively. First conductive pads 1521 are disposed on second ends 152 of all gate control lines, so that the second end 152 of the gate control line is electrically connected to the second conductive pad on the first circuit board 19 via the first conductive pad 1521.

Certainly, in some other examples, first conductive pads 1521 may be disposed on second ends 152 of some gate control lines 15, and no first conductive pad 1521 may be disposed on second ends 152 of some gate control lines 15. The second ends 152 of the some gate control lines 15 are electrically connected to the first circuit board 19 and the power supply chip in another electrical connection manner.

The first conductive pad 1521 and the second conductive pad may be in conductive contact and fastened through bonding. This is simple and quick, has high implementability, and helps reduce production implementation difficulty.

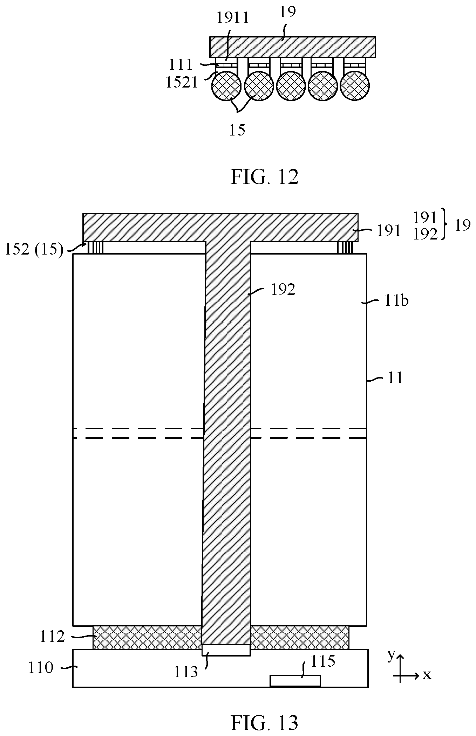

FIG. 12 is a partially enlarged cross-sectional view of connection between the gate control line and the first circuit board in FIG. 11.

Refer to FIG. 12. For example, the display may further include a conductive adhesive layer 111 that has electrical conductivity and bonding performance. For example, the conductive adhesive layer 111 may be an anisotropic conductive film (anisotropic conductive film, ACF for short). The conductive adhesive layer 111 may be disposed between the first conductive pad 1521 and a second conductive pad 1911, so that the first conductive pad 1521 is fastened to the second conductive pad 1911 via the conductive adhesive layer 111, and the first conductive pad 1521 is electrically connected to the second conductive pad 1911.

Alternatively, in some examples, the first conductive pad 1521 and the second conductive pad 1911 may be fastened and electrically connected through welding, snap-fit connection, or the like. In some examples, the first circuit board 19 and the second circuit board 112 may be connected to a same third circuit board 110 and power supply chip of the electronic device, so that two ends of the gate control line 15 are connected to the same power supply chip.

FIG. 13 is a diagram of a back structure of a display in the electronic device in FIG. 10.

For example, as shown in FIG. 13, the first circuit board 19 may include a first sub-circuit board 191 and a second sub-circuit board 192, and the first sub-circuit board 191 is electrically connected to the second end 152 of the gate control line 15. For example, the first conductive pad is disposed on the first sub-circuit board 191. In the two ends of the gate control line 15, the second end 152 is disposed closer to the third peripheral area 10b (refer to FIG. 10). The first sub-circuit board 191 may also be disposed adjacent to the third peripheral area 10b, to facilitate connection and help reduce impedance of a connection path.

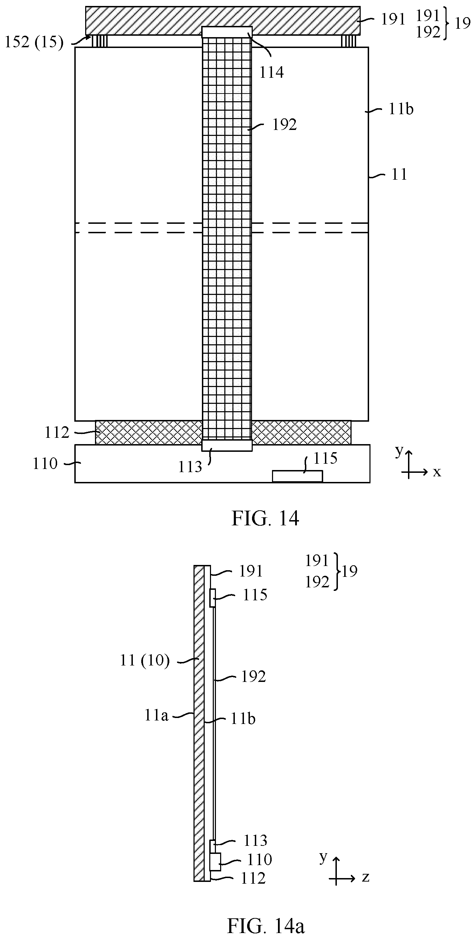

Still refer to FIG. 13. In the two ends of the gate control line 15, the first end 151 is disposed closer to the second peripheral area 10a. For example, the first end 151 may be located in the second peripheral area 10a, to facilitate electrical connection between the first end 151 and the drive chip 17. The second circuit board 112 may be disposed close to the second peripheral area 10a, and the third circuit board 110 may be disposed close to the second circuit board 112. This facilitates electrical connection between the drive chip 17 and the power supply chip and reduces impedance of a connection path. In other words, in the second direction (y direction), the first sub-circuit board 191 and the third circuit board 110 are respectively located on two sides of the substrate 11. At least a part of the second sub-circuit board 192 may be located on a second surface 11b of the substrate 11 (refer to FIG. 14a), so that the second sub-circuit board 192 and the substrate 11 at least partially overlap in a thickness direction. One end of the second sub-circuit board 192 may be electrically connected to the first sub-circuit board 191, and the other end of the second sub-circuit board 192 may be electrically connected to the third circuit board 110. Therefore, the first sub-circuit board 191 and the third circuit board 110 are electrically connected, without affecting display effect of the display area.

The first sub-circuit board 191 may be a flexible circuit board, and can be bent and folded. Therefore, the first sub-circuit board 191 can be bent, to reduce space occupied by the first sub-circuit board 191 in the second direction, and further reduce space occupied by the entire display in the second direction. For example, after the first sub-circuit board 191 is bent, two parts of the first sub-circuit board 191 may overlap in the thickness direction, or a part, of the first sub-circuit board 191, located on the second surface 11b of the substrate 11 backs on the first surface 11a (refer to FIG. 14a), so that the part of the first sub-circuit board 191 overlaps the substrate 11 in the thickness direction. This reduces occupied space.

The second sub-circuit board 192 may also be a flexible circuit board, to facilitate electrical connection between the first sub-circuit board 191 and the third circuit board 110 via the second sub-circuit board 192.

Still refer to FIG. 13. For example, a first connector 113 may be disposed on the first circuit board 19. For example, the first connector 113 is disposed on an end that is of the second sub-circuit board 192 and that backs on the first sub-circuit board 191, and the second sub-circuit board 192 may be electrically connected to the third circuit board 110 via the first connector 113. For example, the third circuit board 110 may have a plug-connection location that fits the first connector 113. For example, one of the first connector 113 and the plug-connection location may be a plug connector, and the other may be a connector base. The plug connector and the connector base may be inserted and electrically connected, so that the second sub-circuit board 192 is electrically connected to the third circuit board 110 via the plug connector fitting with the connector base.

Certainly, in some examples, the first sub-circuit board 191 may alternatively be a rigid circuit board. Correspondingly, in some examples, the second sub-circuit board 192 may also be a rigid circuit board.

As shown in FIG. 13, the first sub-circuit board 191 and the second sub-circuit board 192 may be an integrated structure. For example, the first circuit board 19 may be an integrated flexible circuit board, and a part of the first circuit board 19 is the first sub-circuit board 191, and another part of the first circuit board 19 is the second sub-circuit board 192. For example, the first circuit board 19 may be divided into a partial area extending in the first direction and a partial area extending in the second direction, so that the first circuit board 19 may be a T-shaped flexible circuit board. The partial area extending in the first direction may form the first sub-circuit board 191, and the partial area extending in the second direction may form the second sub-circuit board 192.

Alternatively, the first sub-circuit board 191 and the second sub-circuit board 192 may be separately formed, and the first sub-circuit board 191 and the second sub-circuit board 192 may be connected in a conductive connection manner, for example, by using a connector or through welding. Compared with the integrated structure of the first sub-circuit board and the second sub-circuit board, the structures of the first sub-circuit board and the second sub-circuit board that are separate are simple, the separate forming process is simple and easy to implement. In addition, the disposed locations of the first sub-circuit board and the second sub-circuit board are flexible, to meet a plurality of layout requirements.

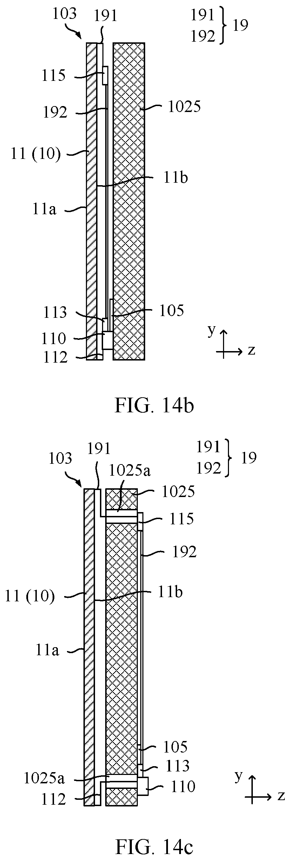

FIG. 14 is another diagram of a back structure of a display in an electronic device according to an embodiment of this application.

For example, as shown in FIG. 14, the display may further include a second connector 114, and the first sub-circuit board 191 may be electrically connected to the second sub-circuit board 192 via the second connector 114. In other words, the first sub-circuit board 191 and the second sub-circuit board 192 may be separately formed, and then electrically connected via the second connector 114.

A connection implementation of the second connector 114 may be the same as that of the first connector 113. For example, the second connector 114 may also include a plug connector or a connector base. For a specific implementation, refer to the first connector 113.

When the display, the middle frame, and the like are assembled to form the electronic device, the third circuit board 110 may be electrically connected to a main circuit board 105 on the middle plate. For example, as shown in FIG. 14, the electronic device may further include a mainboard connector 115, and the third circuit board 110 is electrically connected to the main circuit board 105 via the mainboard connector 115. For an implementation of the mainboard connector 115, refer to the first connector 113.

In some examples, the main circuit board in the electronic device may be used as the third circuit board 110. Alternatively, the third circuit board 110 may be another circuit board disposed in the electronic device.

The second circuit board 112 may be a flexible circuit board. Therefore, the second circuit board 112 can be bent, to reduce space occupied by the second circuit board 112 in the second direction, and further reduce space occupied by the entire display in the second direction. For example, after the second circuit board 112 is bent, two parts of the second circuit board 112 may overlap in the thickness direction, or a part, of second circuit board 112, located on the second surface 11b of the substrate 11 backs on the first surface 11a (refer to FIG. 14a), so that the part of second circuit board 112 overlaps the substrate 11 in the thickness direction. This reduces occupied space.

The third circuit board 110 may be a rigid circuit board. Certainly, in some examples, the second circuit board 112 may alternatively be a flexible circuit board. In some examples, the third circuit board 110 may alternatively be a flexible circuit board.

As shown in FIG. 13 and FIG. 14, in the second direction, the third circuit board 110 may be located on a side that is of the second circuit board 112 and that backs on the substrate 11.

FIG. 14a is another partial side view of an electronic device according to an embodiment of this application.

Alternatively, as shown FIG. 14a, in the thickness direction, the third circuit board 110 may be located on the second surface 11b of the substrate 11, that is, in the thickness direction, projection of the third circuit board 110 at least partially overlaps projection of the substrate 11. This helps reduce an overall length of the display and the third circuit board.

In this embodiment of this application, it may be understood that the second surface 11b of the substrate 11 of the display panel 10 faces a surface of the middle plate when the display, the middle frame, and the like are assembled to form the electronic device. This ensures that the first surface 11a of the substrate 11 can be exposed, so that an image displayed in the display area AA can be seen.

FIG. 14b is a diagram of assembly of a display and a middle plate of a middle frame in FIG. 14a. For example, as shown in FIG. 14b, the display 103 formed by assembling the display panel 10, the first circuit board 19, the second circuit board 112, and the like, the third circuit board 110, and the power supply chip (not shown in the figure) may be located on one side of the middle plate 1025 in the thickness direction. During actual assembly, the gate control lines, the pixel units, and the like are first disposed on the substrate 11, to form the display panel 10; the display panel 10, the drive chip, the first circuit board 19, the second circuit board 112, and the like are assembled together, to form the display; and then the entire display is attached to a surface of the middle frame 102, and the third circuit board 110 and the power supply chip may be assembled on the surface. The main circuit board 105 may be further disposed on the surface, and the third circuit board 110 is connected to the main circuit board 105, and the third circuit board 110 is connected to the first circuit board 19 and the second circuit board 112. Therefore, assembly of the display and the middle frame is completed. The assembly manner is simple and easy to operate.

It may be understood that at least a part of the first circuit board 19 (for example, at least a part of the second sub-circuit board 192) is located on the second surface of the substrate 11, and the display, the power supply chip, and the third circuit board 110 are assembled on one side of the middle plate 1025. The third circuit board 110 and the at least a part of the first circuit board 19 are between the second surface 11b of the substrate 11 and one surface of the middle plate 1025, and an overall size of the display and the middle plate 1025 in the thickness direction is large.

FIG. 14c is another diagram of assembly of a display and a middle plate in an electronic device according to an embodiment of this application.

Alternatively, as shown in FIG. 14c, the display panel 10 and the drive chip (not shown in the figure) may be located on one side of the middle plate 1025, and the third circuit board 110 and the power supply chip (not shown in the figure) may be located on a surface that is of the middle plate 1025 and that backs on the display panel 10.

For example, the middle plate 1025 may be provided with a first through hole 1025a and a second through hole 1025b, and the first through hole 1025a and the second through hole 1025b may penetrate the middle plate 1025 in the thickness direction. The first circuit board 19 may be disposed through the first through hole 1025a. In other words, a part (for example, the first sub-circuit board 191) of the first circuit board 19 may be electrically connected to the gate control line (not shown in the figure) on the substrate 11, and another part (for example, the first sub-circuit board 191 and the second sub-circuit board 192) of the first circuit board 19 may pass through the first through hole 1025a to be electrically connected to the third circuit board 110.

The second circuit board 112 may be disposed through the second through hole 1025b. In other words, a part of the second circuit board 112 may be electrically connected to the gate control line (or the drive chip) on the substrate 11, and another part of the second circuit board 112 may pass through the second through hole 1025b to be electrically connected to the third circuit board 110. In comparison with the display and the third circuit board being located on one side of the middle plate 1025 in FIG. 14b, the third circuit board 110 and the first circuit board 19 between the second surface 11b of the substrate 11 and the middle plate 1025 are not disposed on middle plate 1025, to help reduce overall thickness of the display and the middle plate 1025.

In the example in which the electronic device is a foldable electronic device, the third circuit board 110 may be located in one of the middle frames, and the first circuit board may be a cross-shaft circuit board of the electronic device; or the first circuit board 19 may be a flexible circuit board that is separately disposed in the display and that can be disposed through a cross-shaft hole of the rotating shaft.

Alternatively, in some examples, the first circuit board 19 and the second circuit board 112 may be respectively connected to two third circuit boards 110 and two power supply chips, so that two ends of the gate control line are respectively connected to two power supply chips. The two power supply chips may be electrically connected.

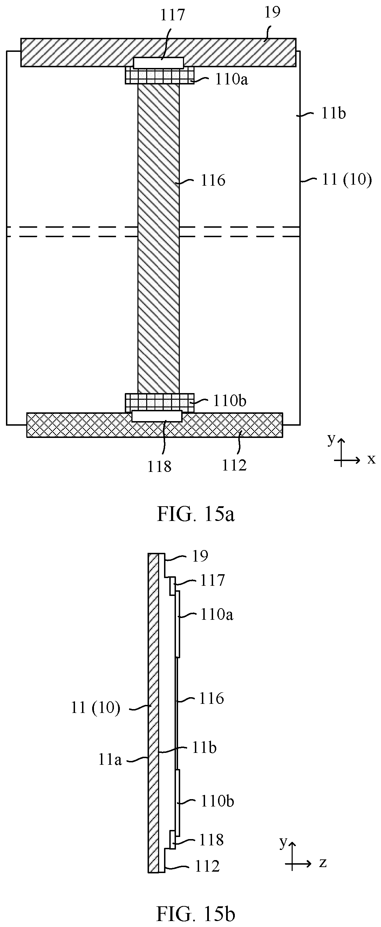

FIG. 15a is another diagram of a structure of connection between a display and a third circuit board according to an embodiment of this application. FIG. 15b is a side view of a structure of connection between the display and the third circuit board in FIG. 15a.

For example, as shown in FIG. 15a, the electronic device includes two third circuit boards, for example, a third circuit board 110a and a third circuit board 110b. With reference to FIG. 15b, the two third circuit boards may be located on the second surface 11b of the substrate 11.

One power supply chip may be disposed on each third circuit board. The first circuit board 19 may be electrically connected to one third circuit board and one power supply chip, and the second circuit board 112 may be electrically connected to the other third circuit board and the other power supply chip. For example, the first circuit board 19 may be electrically connected to the third circuit board 110a, and the second circuit board 112 may be electrically connected to the third circuit board 110b.

The electronic device may further include a fourth circuit board 116, and the two third circuit boards 110 may be electrically connected via the fourth circuit board 116. This increases flexibility of connecting the gate control line to the power supply chip, and expands applicable ranges.

A third connector 117 may be disposed on the first circuit board 19, and a fourth connector 118 may be disposed on the second circuit board 112. The first circuit board 19 may be electrically connected to the third circuit board 110a via the third connector 117, and the second circuit board 112 may be electrically connected to the third circuit board 110b via the fourth connector 118. Connection implementations of the third connector 117 and the fourth connector 118 may be the same as that of the first connector 113. For details, refer to the foregoing implementation of the first connector 113.

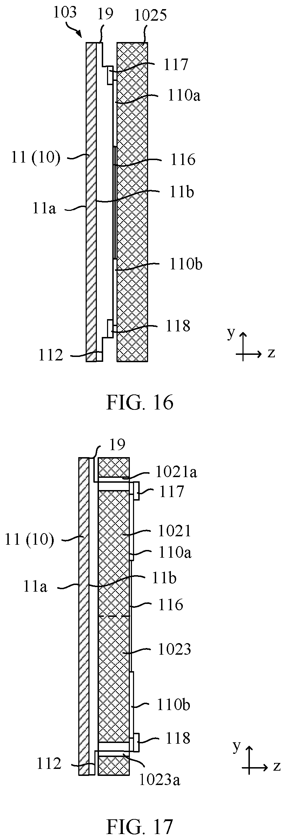

FIG. 16 is a diagram of assembly of the display in FIG. 15b and a middle plate of a middle frame. Correspondingly, the display 103 formed by assembling the display panel 10, the first circuit board 19, the second circuit board 112, and the like, the third circuit board 110a, the third circuit board 110b, and the power supply chip (not shown in the figure) may be located on one side of the middle plate 1025 in the thickness direction. During actual assembly, the display panel 10, the drive chip, the first circuit board 19, the second circuit board 112, and the like may be assembled together, to form the display; and then the entire display is attached to a surface of the middle frame 102, and the third circuit board 110a, the third circuit board 110b, and the fourth circuit board 116 may be assembled on the surface. In other words, at least the third circuit board and the fourth circuit board 116 are between the second surface 11b of the substrate 11 and one surface of the middle plate 1025. An overall size of the display and the middle plate 1025 in the thickness direction is large.

Alternatively, the display panel and the drive chip may be located on one side of the middle plate, and the third circuit board and the fourth circuit board may be located on a side that is of the middle plate and that backs on the display panel. Therefore, the third circuit board and the fourth circuit board between the second surface of the substrate and the middle plate are not disposed on middle plate, to help reduce overall thickness of the display and the middle plate.

FIG. 17 is another diagram of assembly of a display and a middle plate in an electronic device according to an embodiment of this application.

For example, as shown in FIG. 17, the electronic device is a foldable electronic device. The third circuit board 110a and the third circuit board 110b may be located in the two middle frames, for example, the third circuit board 110a may be located on the middle plate 1021 of the first middle frame, and the third circuit board 110b may be located on the middle plate 1023 of the second middle frame. The fourth circuit board 116 may be a cross-shaft circuit board of the electronic device. Alternatively, the fourth circuit board 116 may be a flexible circuit board, separately disposed in the electronic device, that can pass through the cross-shaft hole of the rotating shaft.

The display panel 10 and the drive chip are located on one side of the middle plate 1021 and the middle plate 1023, and the third circuit board 110a, the third circuit board 110b, and the fourth circuit board 116 are located on surfaces that are of the middle plate 1021 and the middle plate 1023 and that back on the display panel 10.

The middle plate 1021 and the middle plate 1023 may be respectively provided with a first through hole 1021a and a second through hole 1023a. The first circuit board 19 is disposed through the first through hole 1021a. A part of the first circuit board 19 may be electrically connected to the gate control line (not shown in the figure) on the substrate 11, and a part of the first circuit board 19 may pass through the first through hole 1021a to be electrically connected to the third circuit board 110a.

The second circuit board 112 may be disposed through the second through hole 1023a, a part of the second circuit board 112 may be electrically connected to the gate control line (or the drive chip) on the substrate 11, and another part of the second circuit board 112 may pass through the second through hole 1023a to be electrically connected to the third circuit board 110b.

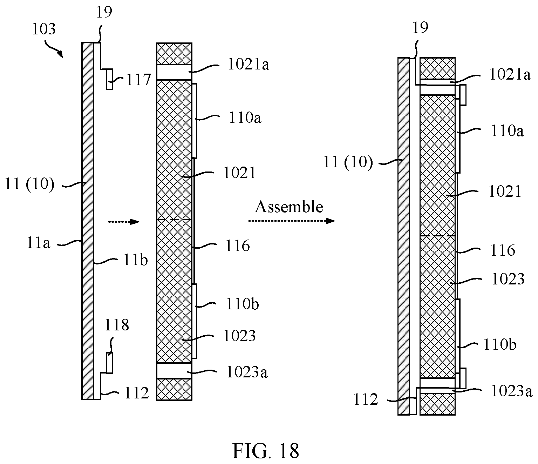

FIG. 18 is a diagram of an assembly process of the display and the middle plate in FIG. 17.

For example, as shown in FIG. 18, during actual assembly, the display panel 10, the first circuit board 19, the second circuit board 112, and the like may be first assembled together, to form the display 103; and the third circuit board 110a and the third circuit board 110b are respectively fastened to surfaces that are of the middle plate 1021 and the middle plate 1023 and that back on the display panel 10, so that the fourth circuit board 116 is disposed through the rotating shaft, and is connected to the third circuit board 110a and the third circuit board 110b. The second surface 11b of the substrate 11 is opposite to surfaces of the middle plate 1021 and the middle plate 1023. The substrate 11 is attached and fastened to the middle plate 1021 and the middle plate 1023, and a part of the first circuit board 19 passes through the first through hole 1021a of the middle plate 1021 to be electrically connected to the third circuit board 110a, and a part of the second circuit board 112 passes through the second through hole 1023a of the middle plate 1023 to be electrically connected to the third circuit board 110b. This implements assembly of the display and the two middle plates.

In the descriptions of embodiments of this application, it should be noted that, unless otherwise clearly specified and defined, the term "mounting", "connected to", or "connection" should be understood in a broad sense, for example, may be a fixed connection, or may be an indirect connection through an intermediate medium, or may be an internal communication between two elements or an interaction relationship between two elements. A person of ordinary skill in the art may understand specific meanings of the foregoing terms in embodiments of this application based on specific cases. The terms such as "first", "second", "third", "fourth", and the like (if any) are intended to distinguish between similar objects but do not necessarily indicate a specific order or sequence.

Finally, it should be noted that the foregoing embodiments are merely used to describe the technical solutions in embodiments of this application, but not to limit the technical solutions. Although embodiments of this application are described in detail with reference to the foregoing embodiments, a person of ordinary skill in the art should understand that the technical solutions described in the foregoing embodiments may still be modified, or some or all of technical features thereof may be equivalently replaced. However, these modifications or replacements do not depart from the scope of the technical solutions in embodiments of this application.

## Claims

1. A display, comprising a display panel, wherein the display panel comprises:
a display area;
a first peripheral area, wherein the first peripheral area and the display area are adjacent in a first direction;
a plurality of pixel groups, wherein the plurality of pixel groups are located in the display area, the plurality of pixel groups are sequentially arranged in a second direction, each pixel group comprises a plurality of pixel units sequentially arranged in the first direction, and the first direction intersects the second direction; and
a gate control line, wherein the gate control line is disposed in at least the first peripheral area, the gate control line extends along the second direction, and the gate control line is electrically connected to the plurality of pixel units in at least one pixel group, wherein
the gate control line comprises a first end and a second end that are opposite to each other in the second direction, the first end and the second end are configured to electrically connect to a power supply chip, and a gate control signal of the power supply chip is separately transmitted from the first end and the second end to the gate control line.

2. The display according to claim 1, wherein the peripheral area further comprises a second peripheral area and a third peripheral area, and the second peripheral area and the third peripheral area are respectively located outside two sides of the display area in the second direction; and
the first end of the gate control line is located in the second peripheral area, and the second end of the gate control line is located outside a side that is of the third peripheral area and that backs on the display area.

3. The display according to claim 2, further comprising a first circuit board, wherein the second end of the gate control line is electrically connected to the first circuit board, and the first circuit board is configured to electrically connect to the power supply chip.

4. The display according to claim 3, wherein a first conductive pad is disposed on the second end of the gate control line, and a second conductive pad is disposed on the first circuit board; and
the display further comprises a conductive adhesive layer, and the first conductive pad and the second conductive pad are electrically connected via the conductive adhesive layer.

5. The display according to claim 3 or 4, further comprising a drive chip, wherein the drive chip is located in the second peripheral area, the first end of the gate control line is electrically connected to the drive chip, and the drive chip is configured to electrically connect to the power supply chip.

6. The display according to claim 5, further comprising a second circuit board, wherein the drive chip is electrically connected to the second circuit board, and the second circuit board is configured to electrically connect to a third circuit board on which the power supply chip is disposed; and
the first circuit board is configured to electrically connect to the third circuit board.

7. The display according to claim 6, wherein the display panel further comprises a substrate, the substrate comprises a first surface and a second surface that are opposite to each other, and the drive chip, at least a part of the gate control line, and the pixel units are located on the first surface;
the first circuit board comprises a first sub-circuit board and a second sub-circuit board, the first sub-circuit board is disposed adjacent to the third peripheral area, and the first sub-circuit board is electrically connected to the second end of the gate control line;
the second circuit board is disposed adjacent to the second peripheral area; and
at least a part of the second sub-circuit board is located on the second surface, one end of the second sub-circuit board is electrically connected to the first sub-circuit board, and the other end of the second sub-circuit board is configured to electrically connect to the third circuit board that is disposed adjacent to the second circuit board.

8. The display according to claim 7, wherein the first sub-circuit board and the second sub-circuit board each comprise a flexible circuit board; and
a first connector is disposed on the second sub-circuit board, and the first connector is configured to electrically connect to the third circuit board.

9. The display according to claim 8, further comprising a second connector, wherein the first sub-circuit board is electrically connected to the second sub-circuit board via the second connector.

10. The display according to claim 6, wherein a third connector is disposed on the first circuit board, and a fourth connector is disposed on the second circuit board; and
the third connector and the fourth connector are respectively configured to electrically connect to the two interconnected third circuit boards.

11. The display according to any one of claims 1 to 10, wherein the peripheral area further comprises a fourth peripheral area, and the first peripheral area and the fourth peripheral area are respectively located outside the two sides of the display area in the first direction; and
the gate control line is distributed in the fourth peripheral area.

12. The display according to any one of claims 1 to 11, wherein the gate control line comprises one or more of a start signal line, a gate high voltage signal line, a gate low voltage signal line, and a clock signal line.

13. The display according to claim 12, wherein the gate control line comprises the gate high voltage signal line and the gate low voltage signal line.

14. An electronic device, comprising a power supply chip, a middle frame, and the display according to any one of claims 1 to 13, wherein the display is fastened to the middle frame;
the middle frame comprises a middle plate and a side frame, the side frame is disposed around the middle plate, and a second surface of a substrate of the display is opposite to a surface of the middle plate; and
the power supply chip is electrically connected to a first end and a second end of a gate control line of the display.

15. The electronic device according to claim 14, further comprising a third circuit board, wherein the power supply chip is disposed on the third circuit board and is electrically connected to the third circuit board, and the third circuit board is electrically connected to a first circuit board and a second circuit board of the display; and
the display, the power supply chip, and the third circuit board are located on one side of the middle plate.

16. The electronic device according to claim 15, further comprising the third circuit board, wherein the power supply chip is disposed on the third circuit board and is electrically connected to the third circuit board;
a display panel and a drive chip of the display are located on one side of the middle plate, and the third circuit board and the power supply chip are located on a surface that is of the middle plate and that backs on the display panel; and
the middle plate is provided with a first through hole and a second through hole, a part of a first circuit of the display passes through the first through hole and is electrically connected to the third circuit board, and a part of the second circuit board of the display passes through the second through hole and is electrically connected to the third circuit board.

17. The electronic device according to claim 16, further comprising a rotating shaft, wherein there are at least two middle frames, the two middle frames are respectively disposed on two sides of the rotating shaft, the two middle frames rotatably fit with each other via the rotating shaft, and the display is disposed on the at least two middle frames and the rotating shaft;
the power supply chip and the third circuit board are separately disposed in the two middle frames, and the rotating shaft is provided with a cross-shaft hole; and
the electronic device further comprises a fourth circuit board, and the fourth circuit board passes through the cross-shaft hole and is electrically connected to the two third circuit boards.
